(19) 

**Europäisches Patentamt**
**European Patent Office**
**Office européen des brevets**

(11) **EP 4 586 524 A1**

(12) **EUROPEAN PATENT APPLICATION**
published in accordance with Art. 153(4) EPC

(43) Date of publication:
**16.07.2025 Bulletin 2025/29**

(21) Application number: **23870582.6**

(22) Date of filing: **21.09.2023**

(51) International Patent Classification (IPC):
***H04L 1/00*** (2006.01)

(52) Cooperative Patent Classification (CPC):
**H04L 1/00**

(86) International application number:
**PCT/CN2023/120418**

(87) International publication number:
**WO 2024/067350 (04.04.2024 Gazette 2024/14)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **29.09.2022 RU 2022125446**

(71) Applicant: **Huawei Technologies Co., Ltd.**
**Shenzhen, Guangdong 518129 (CN)**

(72) Inventors:
• **IVANOV, Fedor**
 **Ulitsa 190121 (RU)**
• **QIN, Kangjian**
 **Shenzhen, Guangdong 518129 (CN)**
• **ZHANG, Huazi**
 **Shenzhen, Guangdong 518129 (CN)**
• **WANG, Jun**
 **Shenzhen, Guangdong 518129 (CN)**

(74) Representative: **Gill Jennings & Every LLP**
**The Broadgate Tower**
**20 Primrose Street**
**London EC2A 2ES (GB)**

(54) **METHOD FOR ENCODING AND DECODING CONCATENATED CODE, AND COMMUNICATION APPARATUS**

(57) Embodiments of this application provide an encoding and decoding method of a concatenated code and a communication apparatus. The concatenated code uses a polar code as an outer code, and an N-ER-LDPC code provided in this application as an inner code. This application provides a base matrix of the E-NR-LDPC code and a lifting strategy of the base matrix. A parity-check matrix of the N-ER-LDPC code may be obtained by lifting the base matrix according to the lifting strategy. The parity-check matrix has an evident external feature, and can meet a rate compatibility requirement while improving decoding performance.

FIG. 4

## Description

This application claims priority to Russian Patent Application No. 2022125446, filed with the Federal Service for Intellectual Property on September 29, 2022 and entitled "CODING SCHEME OF NESTED CONCATENATED CODE", which is incorporated herein by reference in its entirety.

## TECHNICAL FIELD

Embodiments of this application relate to the field of channel coding, and more specifically, to an encoding and decoding method of a concatenated code and a communication apparatus.

## BACKGROUND

In the field of channel coding, a concatenated code (concatenated code) can achieve a higher encoding gain and a lower decoding delay. A concatenated encoding scheme usually includes an inner code and an outer code. A function of the inner code may be considered as obtaining a better super channel by "noise reduction" on a physical channel, so that a channel condition observed by the outer code is better than that of an original physical channel.

Currently, there are many schemes for concatenating different codewords, for example, a concatenated code scheme of a polar code and a low-density parity-check (low-density parity-check, LDPC) code, a concatenated code scheme of a Reed-Solomon (Reed-Solomon, RS) code and a polar code, and a concatenation scheme of a polar code and a low-density generator matrix (low-density generator matrix, LDGM). However, in general, decoding performance of such concatenated codes needs to be improved.

## SUMMARY

Embodiments of this application provide an encoding and decoding method of a concatenated code, to improve decoding performance of the concatenated code and meet a rate compatibility requirement.

According to a first aspect, an encoding method of a concatenated code is provided. The method includes: encoding a to-be-encoded message bit sequence by using a polar code, to obtain a first encoded codeword with a length of N_o, where N_o is a positive integer; encoding a second encoded codeword by using an improved low-density parity-check (low-density parity-check, LDPC) code, to obtain a concatenated code codeword with a length of N_i, where the second encoded codeword is determined based on the first encoded codeword, and N_i is a positive integer; and outputting the concatenated code codeword, where the first t columns of a base matrix of the improved LDPC code are all-zero columns, t is a positive integer, $2 \leq t < T$, T is equal to a ratio of N_o to p, p is a multiple by which the base matrix needs to be extended, and p is a positive integer; and a parity-check matrix of the improved LDPC code includes at least s columns with a column weight of 1, the at least s columns include the last (N_i-N_o) columns, and s is a positive integer.

The second encoded codeword is the same as the first encoded codeword, or the second encoded codeword is obtained by interleaving the first encoded codeword.

In this embodiment of this application, because the first t columns of the base matrix of the improved LDPC code are all-zero columns, in the method provided in this embodiment of this application, in a large iterative decoding process, a soft value of the polar code, an outer code, and a soft value of the improved LDPC code are not updated at the all-zero columns, and update of a part of soft values can improve performance of large iterative decoding.

In addition, because the column weights of the last (N_i-N_o) columns of the parity-check matrix of the improved LDPC code are 1, the method provided in this embodiment of this application has low encoding complexity, and can implement rate compatibility.

With reference to the first aspect, in some implementations of the first aspect, a size of the base matrix is m rows and n columns, and the method further includes: constructing a row vector with a size of m and a column vector with a size of v, where any two elements in the row vector are different, any two elements in the column vector are different, m, n, and v are all positive integers, both m and v are less than or equal to p, and v=n, or v=n-t; obtaining a lifting matrix based on the row vector and the column vector; obtaining an updated base matrix based on the lifting matrix and the base matrix; and obtaining the parity-check matrix of the improved LDPC code based on the updated base matrix.

With reference to the first aspect, in some implementations of the first aspect, the obtaining the lifting matrix based on the row vector and the column vector includes: constructing the lifting matrix $\mathbf{M}(i, j) = r_i \cdot c_j \bmod p$, where the row vector is $C_{rows} = (r_1, r_2, ..., r_m)$, $r_i$ is the $i^{th}$ element in the row vector $\mathbf{C}_{rows}$, $1 \leq i \leq m$, the column vector is $\mathbf{C}_{cols} = (c_1, c_2, ..., c_v)$, $c_j$ is the $j^{th}$ element in the column vector $\mathbf{C}_{cols}$, $1 \leq j \leq v$, and mod is a remainder operation.

With reference to the first aspect, in some implementations of the first aspect, the obtaining an updated base matrix based on the lifting matrix and the base matrix includes: if v=n, determining that the updated base matrix $\mathbf{H}_m$ is represented as $\mathbf{H}_m = \mathbf{H}_{opt} \odot \mathbf{M}$; or if v=n-t, determining that the updated base matrix $\mathbf{H}_m$ is represented as $\mathbf{H}_m = \mathbf{H}_{opt2} \odot \mathbf{M}$,

where $\mathbf{H}_{opt}$ is the base matrix, $\mathbf{H}_{opt2}$ is a matrix obtained by extracting a non-zero column in the base matrix, and $\mathbf{M}$ is the lifting matrix.

$\mathbf{H}_{opt}\odot\mathbf{M}$ represents a Hadamard product of $\mathbf{H}_{opt}$ and $\mathbf{M}$, and $\mathbf{H}_{opt2}\odot\mathbf{M}$ represents a Hadamard product of $\mathbf{H}_{opt2}$ and $\mathbf{M}$. The Hadamard product may also be referred to as a basic product.

Based on the foregoing technical solution, because the first t columns of the base matrix are all-zero columns, a column vector with a dimension of v=n-t may be constructed, so that calculation complexity can be reduced.

With reference to the first aspect, in some implementations of the first aspect, the obtaining the parity-check matrix of the improved LDPC code based on the updated base matrix includes: if v=n, extending the updated base matrix by p times, to obtain the parity-check matrix; or if v=n-t, extending the updated base matrix by p times, to obtain an intermediate parity-check matrix, and padding the intermediate parity-check matrix with t*p all-zero columns, to obtain the parity-check matrix.

According to a second aspect, a decoding method of a concatenated code is provided. The method includes: obtaining a channel received vector with a length of N_i, where N_i is a length of an inner code of a concatenated code, the inner code of the concatenated code is an improved LDPC code, an outer code of the concatenated code is a polar code, and N_i is a positive integer; decoding the channel received vector according to a soft input soft output (soft input soft output, SISO) decoding algorithm of the improved LDPC code, to obtain a first soft information sequence with a length of N_i, where the SISO decoding algorithm is related to a parity-check matrix of the improved LDPC code; performing soft information iterative decoding based on a second soft information sequence, the channel received vector, and a preset maximum quantity of iterations of the concatenated code according to a soft successive cancellation list (successive cancellation list, SCL) decoding algorithm of the polar code and the SISO decoding algorithm of the improved LDPC code, to obtain a third soft information sequence, where the second soft information sequence is determined based on the first soft information sequence; performing a hard decision on the third soft information sequence, to obtain an estimated sequence from decoding; and outputting the estimated sequence from decoding, where the first t columns of a base matrix of the improved LDPC code are all-zero columns, t is a positive integer, $2\leq t<T$, T is a ratio of N_o to p, p is a multiple by which the base matrix needs to be extended, and p is a positive integer; and the parity-check matrix of the improved LDPC code includes at least s columns with a column weight of 1, the at least s columns include the last (N_i-N_o) columns, and s is a positive integer.

A receiving end de-interleaves the first soft information sequence, and reads soft information at the first N_o positions from a de-interleaved first soft information sequence, to obtain the second soft information sequence. Alternatively, the receiving end reads soft information at the first N_o positions of the first soft information sequence, to obtain the second soft information sequence.

Decoding of the concatenated code of the polar code and the improved LDPC code (or referred to as an N-ER-LDPC code) provided in this application uses soft information iterative decoding combining the soft SCL decoding algorithm and the SISO decoding algorithm, so that decoding complexity can be reduced.

With reference to the second aspect, in some implementations of the second aspect, a size of the base matrix is m rows and n columns, and the method further includes: constructing a row vector with a size of m and a column vector with a size of v, where any two elements in the row vector are different, any two elements in the column vector are different, m, n, and v are all positive integers, both m and v are less than or equal to p, and v=n, or v=n-t; obtaining a lifting matrix based on the row vector and the column vector; obtaining an updated base matrix based on the lifting matrix and the base matrix; and obtaining the parity-check matrix of the improved LDPC code based on the updated base matrix.

With reference to the second aspect, in some implementations of the second aspect, the obtaining the lifting matrix based on the row vector and the column vector includes: constructing the lifting matrix $\mathbf{M}(i, j)=r_i \cdot c_j \bmod p$, where the row vector is $\mathbf{C}_{rows}=(r_1, r_2, ..., r_m)$, $r_i$ is the $i^{th}$ element in the row vector $\mathbf{C}_{rows}$, $1\leq i\leq m$, the column vector is $\mathbf{C}_{cols}=(c_1, c_2, ..., c_v)$, $c_j$ is the $j^{th}$ element in the column vector $\mathbf{C}_{cols}$, $1\leq j\leq v$, and mod is a remainder operation.

With reference to the second aspect, in some implementations of the second aspect, the obtaining an updated base matrix based on the lifting matrix and the base matrix includes: if v=n, determining that the updated base matrix $\mathbf{H}_m$ is represented as $\mathbf{H}_m=\mathbf{H}_{opt}\odot\mathbf{M}$; or if v=n-t, determining that the updated base matrix $\mathbf{H}_m$ is represented as $\mathbf{H}_m=\mathbf{H}_{opt2}\odot\mathbf{M}$, where $\mathbf{H}_{opt}$ is the base matrix, $\mathbf{H}_{opt2}$ is a matrix obtained by extracting a non-zero column in the base matrix, and $\mathbf{M}$ is the lifting matrix.

$\mathbf{H}_{opt}\odot\mathbf{M}$ represents a Hadamard product of $\mathbf{H}_{opt}$ and $\mathbf{M}$, and $\mathbf{H}_{opt2}\odot\mathbf{M}$ represents a Hadamard product of $\mathbf{H}_{opt2}$ and $\mathbf{M}$. The Hadamard product may also be referred to as a basic product.

Based on the foregoing technical solution, because the first t columns of the base matrix are all-zero columns, a column vector with a dimension of v=n-t may be constructed, so that calculation complexity can be reduced.

With reference to the second aspect, in some implementations of the second aspect, the obtaining the parity-check matrix of the improved LDPC code based on the updated base matrix includes: if v=n, extending the updated base matrix by p times, to obtain the parity-check matrix; or if v=n-t, extending the updated base matrix by p times, to obtain an intermediate parity-check matrix, and padding the intermediate parity-check matrix with t*p all-zero columns, to obtain the parity-check matrix.

According to a third aspect, a decoding method of a concatenated code is provided. The method includes: obtaining a channel received vector with a length of N_i, where N_i is a length of an inner code of a concatenated code, the inner code of the concatenated code is an improved LDPC code, an outer code of the concatenated code is a polar code, and N_i is a positive integer; the first t columns of a base matrix of the improved LDPC code are all-zero columns, t is a positive integer, $2 \leq t < T$, T is equal to a ratio of N_o to p, p is a multiple by which the base matrix needs to be extended, and p is a positive integer; and a parity-check matrix of the improved LDPC code includes at least s columns with a column weight of 1, the at least s columns include the last (N_iN_o) columns, and s is a positive integer; and decoding the channel receive vector, and outputting a decoding result.

In this embodiment of this application, because the first t columns of the base matrix of the improved LDPC code are all-zero columns, in the method provided in this embodiment of this application, in a large iterative decoding process, a soft value of the polar code, an outer code, and a soft value of the improved LDPC code are not updated at the all-zero columns, and update of a part of soft values can improve performance of large iterative decoding.

With reference to the third aspect, in some implementations of the third aspect, a size of the base matrix is m rows and n columns, and the method further includes: constructing a row vector with a size of m and a column vector with a size of v, where any two elements in the row vector are different, any two elements in the column vector are different, m, n, and v are all positive integers, both m and v are less than or equal to p, and v=n, or v=n-t; obtaining a lifting matrix based on the row vector and the column vector; obtaining an updated base matrix based on the lifting matrix and the base matrix; and obtaining the parity-check matrix of the improved LDPC code based on the updated base matrix.

With reference to the third aspect, in some implementations of the third aspect, the obtaining the lifting matrix based on the row vector and the column vector includes: constructing the lifting matrix $\mathbf{M}(i, j) = r_i \cdot c_j \bmod p$ , where the row vector is $\mathbf{C}_{rows} = (r_1, r_2, ..., r_m)$, $r_i$ is the $i^{th}$ element in the row vector $\mathbf{C}_{rows}$, $1 \leq i \leq m$, the column vector is $\mathbf{C}_{cols} = (c_1, c_2, ..., c_v)$, $c_j$ is the $j^{th}$ element in the column vector $\mathbf{C}_{cols}$, $1 \leq j \leq v$, and mod is a remainder operation.

With reference to the third aspect, in some implementations of the third aspect, the obtaining an updated base matrix based on the lifting matrix and the base matrix includes: if v=n, determining that the updated base matrix $\mathbf{H}_m$ is represented as $\mathbf{H}_m = \mathbf{H}_{opt} \odot \mathbf{M}$; or if v=n-t, determining that the updated base matrix $\mathbf{H}_m$ is represented as $\mathbf{H}_m = \mathbf{H}_{opt2} \odot \mathbf{M}$, where $\mathbf{H}_{opt}$ is the base matrix, $\mathbf{H}_{opt2}$ is a matrix obtained by extracting a non-zero column in the base matrix, and $\mathbf{M}$ is the lifting matrix.

$\mathbf{H}_{opt} \odot \mathbf{M}$ represents a Hadamard product of $\mathbf{H}_{opt}$ and $\mathbf{M}$, and $\mathbf{H}_{opt2} \odot \mathbf{M}$ represents a Hadamard product of $\mathbf{H}_{opt2}$ and $\mathbf{M}$. The Hadamard product may also be referred to as a basic product.

Based on the foregoing technical solution, because the first t columns of the base matrix are all-zero columns, a column vector with a dimension of v=n-t may be constructed, so that calculation complexity can be reduced.

With reference to the third aspect, in some implementations of the third aspect, the obtaining the parity-check matrix of the improved LDPC code based on the updated base matrix includes: if v=n, extending the updated base matrix by p times, to obtain the parity-check matrix; or if v=n-t, extending the updated base matrix by p times, to obtain an intermediate parity-check matrix, and padding the intermediate parity-check matrix with t*p all-zero columns, to obtain the parity-check matrix.

According to a fourth aspect, a communication apparatus is provided. The communication apparatus has a function of implementing the method in any one of the first aspect or the possible implementations of the first aspect. The function may be implemented by hardware, or may be implemented by hardware executing corresponding software. The hardware or the software includes one or more units corresponding to the function.

According to a fifth aspect, a communication apparatus is provided. The communication apparatus has a function of implementing the method in any one of the second aspect or the possible implementations of the second aspect, or the communication apparatus has a function of implementing the method in any one of the third aspect or the possible implementations of the third aspect. The function may be implemented by hardware, or may be implemented by hardware executing corresponding software. The hardware or the software includes one or more units corresponding to the function.

According to a sixth aspect, a communication apparatus is provided, and includes a processor and a memory. Optionally, the communication apparatus may further include a transceiver. The memory is configured to store a computer program, and the processor is configured to: invoke and run the computer program stored in the memory, and control the transceiver to receive and send a signal, to enable the communication apparatus to perform the method in any one of the first aspect or the possible implementations of the first aspect.

According to a seventh aspect, a communication apparatus is provided, and includes a processor and a memory. Optionally, the communication apparatus may further include a transceiver. The memory is configured to store a computer program, and the processor is configured to: invoke and run the computer program stored in the memory, and control the transceiver to receive and send a signal, to enable the communication apparatus to perform the method in any one of the second aspect or the possible implementations of the second aspect, or enable the communication apparatus to perform the method in any one of the third aspect or the possible implementations of the third aspect.

According to an eighth aspect, a communication apparatus is provided, and includes a processor and a communication interface. The communication interface is configured to receive data and/or information, and transmit the received data and/or information to the processor, the processor processes the data and/or the information, and the communication interface is further configured to output data and/or information obtained through processing by the processor, so that the method according to any one of the first aspect or the possible implementations of the first aspect is performed.

According to a ninth aspect, a communication apparatus is provided, and includes a processor and a communication interface. The processor processes to-be-sent data and/or information, and the communication interface is further configured to output data and/or information processed by the processor, so that the method in any one of the second aspect or the possible implementations of the second aspect is performed, or the method in any one of the third aspect or the possible implementations of the third aspect is performed.

According to a tenth aspect, a computer-readable storage medium is provided. The computer-readable storage medium stores computer instructions, and when the computer instructions are run on a computer, the method in any one of the first aspect, the second aspect, the third aspect, or the possible implementations of these aspects is performed.

According to an eleventh aspect, a computer program product is provided. The computer program product includes computer program code, and when the computer program code is run on a computer, the method in any one of the first aspect, the second aspect, the third aspect, or the possible implementations of the aspects is performed.

According to a twelfth aspect, a communication system is provided, and includes the communication apparatus according to the fourth aspect and/or the communication apparatus according to the fifth aspect.

**BRIEF DESCRIPTION OF DRAWINGS**

FIG. 1 is a diagram of a system architecture of a communication system applicable to technical solutions of this application;
FIG. 2 is a diagram of a process of a communication system;
FIG. 3 is a diagram of concatenated encoding;
FIG. 4 is a diagram of an encoding and decoding method of a concatenated code according to this application;
FIG. 5 is a schematic flowchart of an encoding and decoding method of a concatenated code according to this application;
FIG. 6 is a diagram of an encoding process of a concatenated code according to this application;
FIG. 7 is a diagram of an encoding process at a transmitting end according to this application;
FIG. 8 is a diagram of a base graph of a base matrix according to this application;
FIG. 9 is a diagram of a technical effect of a parity-check matrix of an improved LDPC code according to this application;
FIG. 10 is a diagram of a decoding process at a receiving end according to this application;
FIG. 11 is a diagram of a soft information iterative decoding scheme at a receiving end according to this application;
FIG. 12 is performance comparison between a solution provided in this application and an existing solution;
FIG. 13 is a block diagram of a communication apparatus according to this application; and
FIG. 14 is a diagram of a structure of a communication apparatus according to this application.

**DESCRIPTION OF EMBODIMENTS**

The following describes technical solutions of this application with reference to accompanying drawings.

The technical solutions of embodiments of this application may be applied to various communication systems, including but not limited to a satellite communication system, a 5th generation (the 5th generation, 5G) system or a new radio (new radio, NR) system, a long term evolution (long term evolution, LTE) system, an LTE frequency division duplex (frequency division duplex, FDD) system, an LTE time division duplex (time division duplex, TDD) system, and the like. The technical solutions provided in this application may be further applied to a future communication system, for example, a 6th generation mobile communication system. In addition, the technical solutions may be further applied to device-to-device (device to device, D2D) communication, vehicle-to-everything (vehicle-to-everything, V2X) communication, machine-to-machine (machine to machine, M2M) communication, machine type communication (machine type communication, MTC), an internet of things (internet of things, IoT) communication system, another communication system, and the like. This is not limited in this specification.

The communication system applicable to this application may include one or more transmitting ends and one or more receiving ends. Optionally, one of the transmitting end and the receiving end may be a terminal device, and the other may be a network device. Alternatively, both the transmitting end and the receiving end are terminal devices. The transmitting end may also be considered as an encoding end or an encoding device, and the receiving end may also be considered as a decoding end or a decoding device.

For example, the terminal device may also be referred to as user equipment (user equipment, UE), an access terminal, a subscriber unit, a subscriber station, a mobile station, a mobile terminal (mobile terminal, MT), a remote station, a remote terminal, a mobile device, a user terminal, a terminal, a wireless communication device, a user agent, or a user apparatus. The terminal device in embodiments of this application may be a device that provides voice and/or data connectivity for a user, and may be configured to connect a person, an object, and a machine, for example, a handheld device or a vehicle-mounted device with a wireless connection function. The terminal device in embodiments of this application may be a mobile phone (mobile phone), a tablet computer (pad), a notebook computer, a palmtop computer, a mobile internet device (mobile internet device, MID), a wearable device, a virtual reality (virtual reality, VR) device, an augmented reality (augmented reality, AR) device, a wireless terminal in industrial control (industrial control), a wireless terminal in self-driving (self-driving), a wireless terminal in remote medical surgery (remote medical surgery), a wireless terminal in a smart grid (smart grid), a wireless terminal in transportation safety (transportation safety), a wireless terminal in a smart city (smart city), a wireless terminal in a smart home (smart home), or the like. Optionally, the UE may serve as a base station. For example, the UE may serve as a scheduling entity that provides a sidelink signal between UEs in V2X, D2D, or the like.

In embodiments of this application, an apparatus configured to implement a function of a terminal may be a terminal, or may be an apparatus that can support the terminal in implementing the function, for example, a chip system or a chip. The apparatus may be installed on the terminal. In embodiments of this application, the chip system may include a chip, or may include a chip and another discrete device.

For example, the network device may be a device having a wireless transceiver function. The network device may be a device providing a wireless communication function service, and is usually located on a network side, including but not limited to a next generation NodeB (gNodeB, gNB) in a 5th generation (5th generation, 5G) communication system, a base station in a 6th generation (6th generation, 6G) mobile communication system, a base station in a future mobile communication system, an access node in a wireless fidelity (wireless fidelity, Wi-Fi) system, an evolved NodeB (evolved NodeB, eNB) in a long term evolution (long term evolution, LTE) system, a radio network controller (radio network controller, RNC), a NodeB (NodeB, NB), a base station controller (base station controller, BSC), a home base station (for example, a home evolved NodeB or a home NodeB, HNB), a baseband unit (base band unit, BBU), a transmission reception point (transmission reception point, TRP), a transmitting point (transmitting point, TP), a base transceiver station (base transceiver station, BTS), and the like. In a network structure, the network device may include a central unit (central unit, CU) node, a distributed unit (distributed unit, DU) node, a RAN device including a CU node and a DU node, or a RAN device including a CU-control plane node, a CU-user plane node, and a DU node. Alternatively, the network device may be a radio controller, a relay station, a vehicle-mounted device, a wearable device, and the like in a cloud radio access network (cloud radio access network, CRAN) scenario. In addition, the base station may be a macro base station, a micro base station, a relay node, a donor node, or a combination thereof. The base station may alternatively be a communication module, a modem, or a chip disposed in the foregoing device or apparatus. The base station may alternatively be a mobile switching center, a device that bears a base station function in D2D, V2X, and M2M communication, a network side device in a 6G network, a device that bears a base station function in a future communication system, or the like. The base station may support networks of a same access technology or different access technologies. This is not limited.

In embodiments of this application, an apparatus configured to implement a function of the network device may be a network device, or may be an apparatus that can support the network device in implementing the function, for example, a chip system or a chip. The apparatus may be installed on the network device. In embodiments of this application, the chip system may include a chip, or may include a chip and another discrete device.

It should be understood that, an encoding or decoding scheme of a concatenated code (concatenated code) provided in this application is a channel encoding or decoding scheme, may be applied to a dedicated network device or a general-purpose device, and may be applied to the various network devices (for example, base station devices) described above or the various terminal devices described above. Specifically, the channel encoding or decoding scheme is mainly implemented by using a channel encoding unit or a channel decoding unit in these devices.

In embodiments of this application, a function of the transmitting end or the receiving end may be implemented by using an application-specific integrated circuit (application-specific integrated circuit, ASIC), a field programmable gate array (field programmable gate array, FPGA), or the like, or may be implemented by using software (for example, program code in a memory). This is not limited.

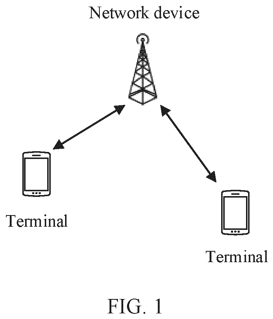

In addition, the technical solutions of this application may be applied to a plurality of communication scenarios. FIG. 1 is a diagram of a system architecture of a communication system applicable to the technical solutions of this application.

As shown in an example in FIG. 1, an encoding and decoding method of a concatenated code provided in this application is applicable to communication between a network device and a terminal, that is, uplink or downlink communication. In this communication scenario, the transmitting end in this specification may be a terminal in uplink communication or a network device in downlink communication, and the receiving end may be a network device in uplink communication or a terminal in downlink communication. In addition, optionally, the technical solutions of this application may also be applied to sidelink communication. In this communication scenario, the transmitting end is a transmitting terminal in sidelink communication, and the receiving end is a receiving terminal in sidelink communication. In addition, the method may be further applied to another communication scenario, and details are not described again.

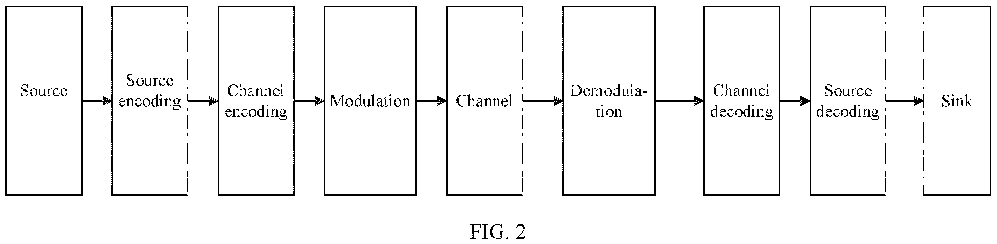

FIG. 2 is a diagram of a process of a communication system. As shown in FIG. 2, channel encoding is located between source encoding and modulation, and is responsible for performing channel encoding on a bit generated by a source. After modulation, a modulation symbol is sent to a receiving end through a noise channel for demodulation, and then channel decoding is performed. Channel decoding is located between demodulation and source decoding, and is responsible for restoring a source bit stream.

The technical solutions of this application relate to a polar code (that is, a polar code), a low-density parity-check (low-density parity-check, LDPC) code, and a concatenated code in the coding field.

The following briefly describes terms or related concepts in this application.

1. Polar code:
Channel encoding and decoding is one of core technologies in the wireless communication field, and a performance improvement of the channel encoding and decoding can directly improve network coverage and a user transmission rate. Currently, a polar code (polar codes) is a channel coding technology that is theoretically proved to be capable of achieving a Shannon limit and that has practical encoding and decoding capabilities with linear complexity. The polar code is a linear block code, and an encoding matrix (also referred to as a generator matrix) of the polar code is $F_N$. An encoding process may be represented by using the following formula:

$$\mathbf{x}_1^N = \mathbf{\mu}_1^N \cdot \mathbf{F}_N \tag{1}$$

$\mathbf{\mu}_1^N = (\mu_1, \mu_2, ..., \mu_N)$ is a binary row vector (that is, an information bit sequence), a length is N, $N=2^n$, and n is a positive integer. $\mathbf{F}_N$ is an NxN matrix, and $\mathbf{F}_N = \mathbf{F}_2^{\otimes(\log_2 N)}$. $F_2^{\otimes(\log_2 N)}$ is defined as a Kronecker (Kronecker) product of

$$\mathbf{F}_2 = \begin{bmatrix} 1 & 0 \\ 1 & 1 \end{bmatrix}$$

$\log_2 N$ matrices $\mathbf{F}_2$, and . The addition and multiplication operations in the foregoing formulas are all addition and multiplication operations in the binary Galois field.

2. Low-density parity-check (low-density parity-check, LDPC) code: a type of linear block code with a sparse parity-check matrix. That is, density of non-zero elements in the parity-check matrix is low. In other words, zero elements in the parity-check matrix are required to be far more than the non-zero elements. An [N, K] linear block code may be understood as encoding an information sequence with a length of K into encoded bits with a code length of N.

3. Base graph: The base graph may be represented as a matrix $m \times n$, and includes a zero element and a non-zero element. The zero element may be represented by 0, -1, null, or the like, and the non-zero element may be represented by 1. The base graph may indicate a position of a non-zero element in a base matrix, that is, row and column positions of the non-zero element in the matrix. In some implementation methods, the base graph may also be simply represented as a table indicating row and column positions of a non-zero element.

4. Base matrix: may be used to construct a parity-check matrix $\mathbf{H}$ of an LDPC code. A size of the base matrix $\mathbf{H}_b$ may be $m \times n$, and is the same as that of a base graph. A size of the corresponding parity-check matrix $\mathbf{H}$ is $(m \cdot p) \times (n \cdot p)$, where p is referred to as a lifting size (lifting size) of the parity-check matrix, or is referred to as a multiple by which the base matrix needs to be extended, and $m, n,$ and $p$ are all positive integers.

An expression of the base matrix may be shown as follows. An element value in a position corresponding to a non-zero element in the base graph is greater than or equal to 0, and an element value in a position corresponding to a zero element may be -1 or null.

$$\mathbf{H}_b = \begin{bmatrix} a_{0,0} & a_{0,1} & \cdots & a_{0,n-1} \\ a_{1,0} & a_{1,1} & \cdots & a_{1,n-1} \\ \vdots & \vdots & \ddots & \vdots \\ a_{m-1,0} & a_{m-1,1} & \cdots & a_{m-1,n-1} \end{bmatrix}.$$

5. Parity-check matrix: An expression of a parity-check matrix of an LDPC code may be shown as follows:

$$\mathbf{H} = \begin{bmatrix} \mathbf{I}(a_{0,0}) & \mathbf{I}(a_{0,1}) & \cdots & \mathbf{I}(a_{0,n-1}) \\ \mathbf{I}(a_{1,0}) & \mathbf{I}(a_{1,1}) & \cdots & \mathbf{I}(a_{1,n-1}) \\ \vdots & \vdots & \ddots & \vdots \\ \mathbf{I}(a_{m-1,0}) & \mathbf{I}(a_{m-1,1}) & \cdots & \mathbf{I}(a_{m-1,n-1}) \end{bmatrix}.$$

Each element $\mathbf{I}(a_{i,j})$ ($0 \le i \le m$-1, $0 \le j \le n$-1) in the parity-check matrix **H** may be a zero matrix or a cyclic shift matrix. If $a_{i,j}$ is greater than or equal to 0, a cyclic shift matrix (for example, $\mathbf{I}(a_{i,j})$) may be obtained by cyclically shifting an identity matrix with a dimension of $p \times p$ by $a_{i,j}$ positions. Therefore, $a_{i,j}$ is also referred to as a shift factor of a cyclic shift matrix. A value range of $a_{i,j}$ may be $-1 \le a_{i,j} < p$.

In other words, each non-zero element $a_{i,j}$ ($0 \le i \le m$-1, $0 \le j \le n$-1) in a base matrix may indicate a quantity of positions by which a corresponding identity matrix in a parity-check matrix constructed by the base matrix needs to be cyclically shifted. For example, $a_{0,0}$ may indicate that a quantity of positions by which an identity matrix $\mathbf{I}(a_{0,0})$ with a dimension of $p \times p$ at the upper left corner of the parity-check matrix needs to be cyclically shifted is $a_{0,0}$. If $\mathbf{I}(a_{0,0})$ is considered as a whole, a position of $\mathbf{I}(a_{0,0})$ in the parity-check matrix is the same as a position of $a_{0,0}$ in the base matrix, that is, at a row 0 and a column 0. A zero element in the base graph or the base matrix is replaced with a $p \times p$ zero matrix.

6. Hadamard product (Hadamard product): The Hadamard product is a type of operation of a matrix.

Assuming that $\mathbf{A}, \mathbf{B} \in \mathbb{C}^{m \times n}$, $\mathbf{A}=\{a_{ij}\}$, $\mathbf{B}=\{b_{ij}\}$, $1 \le i \le m$, and $1 \le j \le n$, a matrix **C** shown in the following is referred to as a Hadamard product of a matrix **A** and a matrix **B**, and is denoted as $\mathbf{C}=\mathbf{A}\odot\mathbf{B}$.

$$\mathbf{C} = \begin{bmatrix} a_{11}b_{11} & a_{12}b_{12} & \cdots & a_{1n}b_{1n} \\ a_{21}b_{21} & a_{22}b_{22} & \cdots & a_{2n}b_{2n} \\ \vdots & \vdots & \ddots & \vdots \\ a_{m1}b_{m1} & a_{m2}b_{m2} & \cdots & a_{mn}b_{mn} \end{bmatrix}.$$

7. Hamming distance: In a code group set, a quantity of corresponding positions in which any two codewords have different values is defined as a Hamming distance between the two codewords. For example, a Hamming distance between a codeword x and a codeword y is d(x, y), and $d(x, y) = \Sigma x[i] \oplus y[i]$, where i=0, 1, ..., n-1, x and y are both n-bit codes, n is a positive integer, and $\oplus$ represents an exclusive OR. For example, a Hamming distance between (00) and (01) is 1, and a Hamming distance between (110) and (101) is 2.

In a code group set, a minimum Hamming distance between any two codes is referred to as a minimum Hamming distance of the code group, or a minimum Hamming weight. A larger minimum Hamming distance indicates a stronger anti-interference capability of a code.

8. Soft value (soft value): or a log-likelihood ratio (log-likelihood ratio, LLR). An LLR of a codeword bit c is defined as log (probability of c=0/probability of c=1). If the LLR of c is greater than 0, c is decided as 0 in hard decision. If the LLR of c is less than 0, c is decided as 1 in hard decision. This is a function of a sign of the LLR. In addition, a magnitude of the LLR reflects reliability of the hard decision, and a larger absolute value of the LLR indicates more definite hard decision.

9. Concatenated code:

When a channel coding technology is applied in practice, many practical factors, such as efficiency, performance, and a delay, often need to be considered. According to the channel coding theory, as a code length N increases, a decoding error rate approaches zero exponentially. Therefore, to improve effectiveness of an error correction code, a long code needs to be used. However, as the code length increases, a code rate decreases accordingly, and complexity and calculation amount of a decoder increase accordingly. The concatenated code is proposed to solve this problem. The concatenated code divides a coding process into several stages, to meet a requirement of channel error correction on a code length, and obtain an error correction capability and a high encoding gain that are close to or even the same as those of the long code. In addition, an increase in encoding and decoding complexity is not significant. In other words, if a system includes a plurality of (at least two) times of encoding, the plurality of times of encoding are considered as concatenated encoding. The concatenated encoding includes outer-code encoding and inner-code encoding. An input of the outer-code encoding is a to-be-encoded information bit sequence, and an output of the outer-code encoding is used as an input of the inner-code encoding. An output of the inner-code encoding is a codeword obtained after the concatenated coding is completed. It should be understood that an outer code and an inner code are relative concepts. For example, a system includes three times of encoding. The first time of encoding is outer-code encoding relative to the second time of encoding, and the second time of encoding is inner-code encoding relative to the first time of encoding. After the first time of encoding is completed, the second time of encoding is outer-code encoding relative to the third time of encoding, and the third time of encoding is inner-code encoding relative to the second time of encoding. For another example, a system includes two times of encoding. Outer-code encoding is first performed, and then inner-code encoding is performed. An output of the outer-code encoding is used as an input of the inner-code encoding.

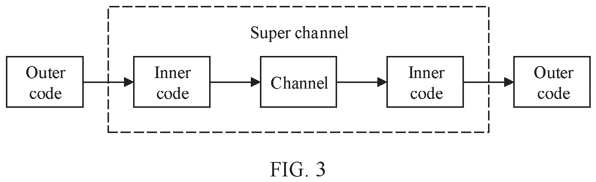

FIG. 3 is a diagram of concatenated encoding. As shown in FIG. 3, a concatenated encoding scheme usually includes an inner code and an outer code. A function of the inner code may be considered as obtaining a better super channel by "noise reduction" on a physical channel, so that a channel condition observed by the outer code is better than that of an original physical channel. The existing research shows that a concatenated code can reduce a block error rate (block error rate, BLER) at all code rates lower than a channel capacity.

In this specification, the outer code and the inner code of the concatenated code are respectively represented as $C_{out}(N\_o, K\_o, D\_o)$ and $C_{in}(N\_i, K\_i, D\_i)$, and the concatenated code is represented as C(N, K, D), where $N=N\_o*N\_i$, $K=K\_o*K\_i$, and $D \geq D\_o*D\_i$. In the brackets, the parameter N represents a code length, K represents a quantity of message bits, and D represents a minimum Hamming distance of the code. In this application, it is not required that both inner and outer codewords are in a same algebraic field. The inner code may be in a binary field, and the outer code may be in a non-binary field. In addition, if both the inner code and the outer code are linear codes, a concatenated codeword is also a linear code.

Decoding of the concatenated code usually uses iterative soft-input soft-output (soft-input soft-output, SISO) decoding. The iterative SISO decoding is sometimes referred to as turbo decoding (turbo decoding). One of key points of this decoding manner is to use a soft output of the 1st decoder as a soft input of the 2nd decoder, and then use a soft output of the 2nd decoder as a soft input of the 1st decoder. In this way, a more reliable decision result is finally generated through cyclical iteration.

There are a plurality of methods for concatenating different codewords. According to a concatenation mode, concatenated codes may be roughly classified into a serial concatenated code and a parallel concatenated code. Currently, there are the following concatenated code schemes:

(1) a polar code+LDPC code serial concatenation scheme;
(2) a parallel concatenation scheme for concatenating polar and LDPC codes by using a parallel concatenated code (parallel concatenated codes, PCC) architecture;
(3) a Reed-Solomon (Reed-Solomon, RS) code+interleaver+polar code concatenation scheme; and
(4) a polar code+low-density generator matrix (low-density generator matrix, LDGM) concatenation scheme.

By concatenating the polar code and the rateless LDPC code, the polar code can obtain an advantage of flexible extension of a code length of the rateless LDPC code, to improve extension flexibility of the polar code. A reason why a rateless structure allows more flexible code length extension of the polar code is that the structure has a nesting feature, and a rateless nested structure ensures that a short code is always a subcode of a long code. As a code length increases, a previously encoded part does not need to be changed, and a code length can be extended by adding only a redundant bit of an extra length. However, an existing concatenated code design of the polar code and the rateless LDPC code is mainly based on a density polarization theory. The Gaussian approximation and the assumption of independence cause an error in this optimization manner. Therefore, performance of a concatenated code scheme obtained in this manner needs to be improved.

In view of this, embodiments of this application provide an encoding and decoding scheme of a concatenated code of a polar code and an improved LDPC code, to further improve decoding performance and construction flexibility of the concatenated code, and meet a rate compatibility requirement.

The "improved LDPC code" provided in this application is different from a conventional LDPC code. Compared with the conventional LDPC code, the improved LDPC code can further reduce a bit error rate (bit error rate, BER) and better meet a rate compatibility requirement. Therefore, the improved LDPC code is also referred to as a nested error reducing-LDPC (nested error reducing-LDPC, N-ER-LDPC) code in this specification.

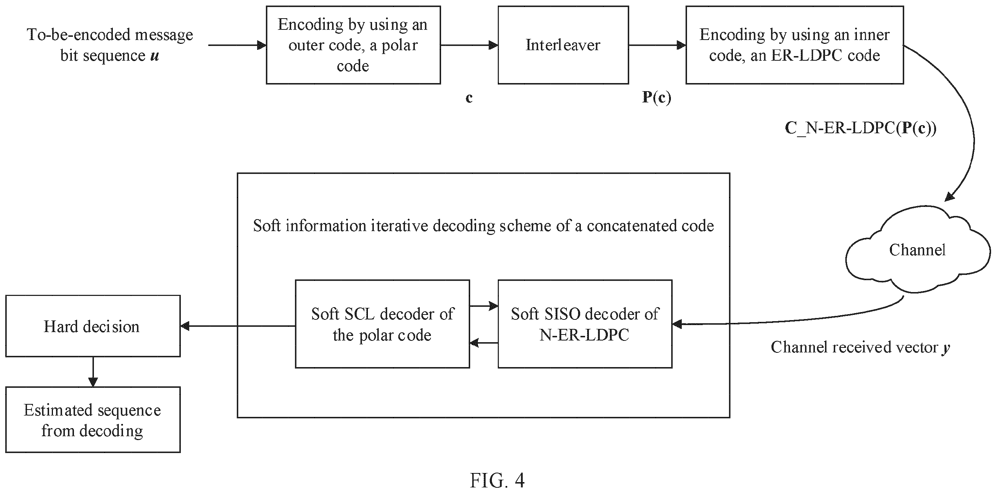

FIG. 4 is a diagram of an encoding and decoding method of a concatenated code according to this application. As shown in FIG. 4, at a transmitting end, a codeword c is first obtained for a to-be-encoded message bit sequence u through a polar code encoder, and after the codeword c is interleaved by an interleaver P, an input sequence P(c) of an N-ER-LDPC code encoder is obtained. P(c) is encoded by using an N-ER-LDPC code, and then a final concatenated codeword C_N-ER-LDPC(P(c)) is obtained, and is sent to a channel for transmission.

At a receiving end, the receiving end performs iterative decoding by using soft information.

The receiving end receives a channel received vector y, and then decodes the channel received vector y by using a soft information iterative decoding scheme of the concatenated code provided in this application. A soft information sequence output by a soft (soft) successive cancellation list (successive cancellation list, SCL) decoder is obtained through soft information iterative decoding based on a preset maximum quantity of iterations, and a final estimated sequence from decoding is obtained through hard decision.

Specifically, an N-ER-LDPC decoder first decodes a sequence received from a channel (referred to as a channel received sequence below), to obtain soft information. The soft information is used as an input of the soft SCL decoder, and the soft information is decoded by the soft SCL decoder to generate a soft value of a decoded sequence. Then, the soft information is subtracted from the soft value, to obtain extrinsic information, and the extrinsic information and the channel received sequence are added and then input to the N-ER-LDPC decoder for decoding, to generate new soft information. Then, an input of the N-ER-LDPC decoder (the input of the N-ER-LDPC decoder is obtained by adding the extrinsic information and the channel received sequence) is subtracted from the new soft information, to obtain new extrinsic information, and the new extrinsic information is input to the soft SCL decoder for decoding, to generate a new soft value of a decoded sequence. The iteration is performed cyclically, and after a maximum quantity of iterations is reached, a hard decision is performed on a soft value of a decoded sequence generated by the soft SCL decoder, to obtain a final estimated sequence.

It should be noted that after the codeword c is obtained for the to-be-encoded message bit sequence u through the polar code encoder, the codeword c may not be interleaved, but is directly encoded by using the N-ER-LDPC code. This is not limited in embodiments of this application. If the codeword c is not interleaved, the decoding process does not include de-interleaving.

The following describes in detail a channel encoding scheme at a transmitting end and a channel decoding scheme at a receiving end.

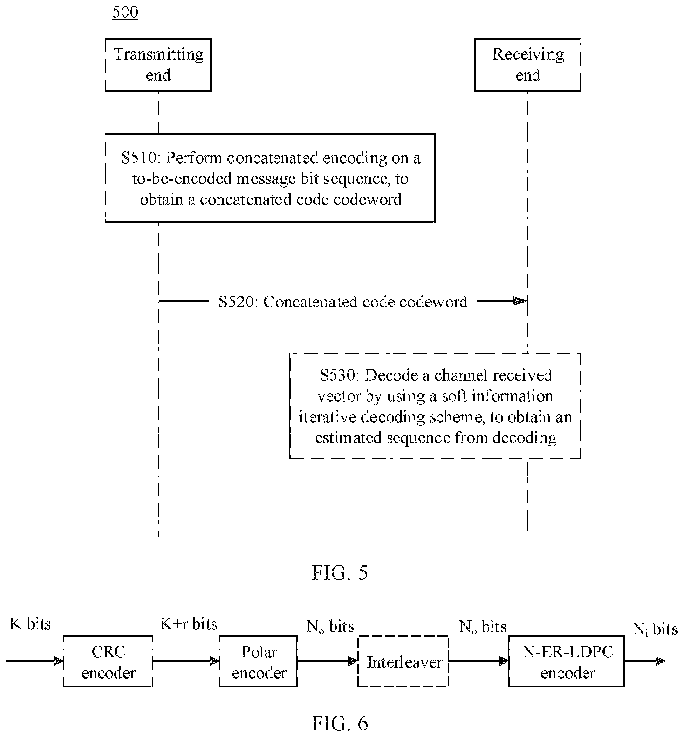

FIG. 5 is a schematic flowchart of an encoding and decoding method 500 of a concatenated code according to this application.

S510: A transmitting end performs concatenated encoding on a to-be-encoded message bit sequence, to obtain a concatenated code codeword.

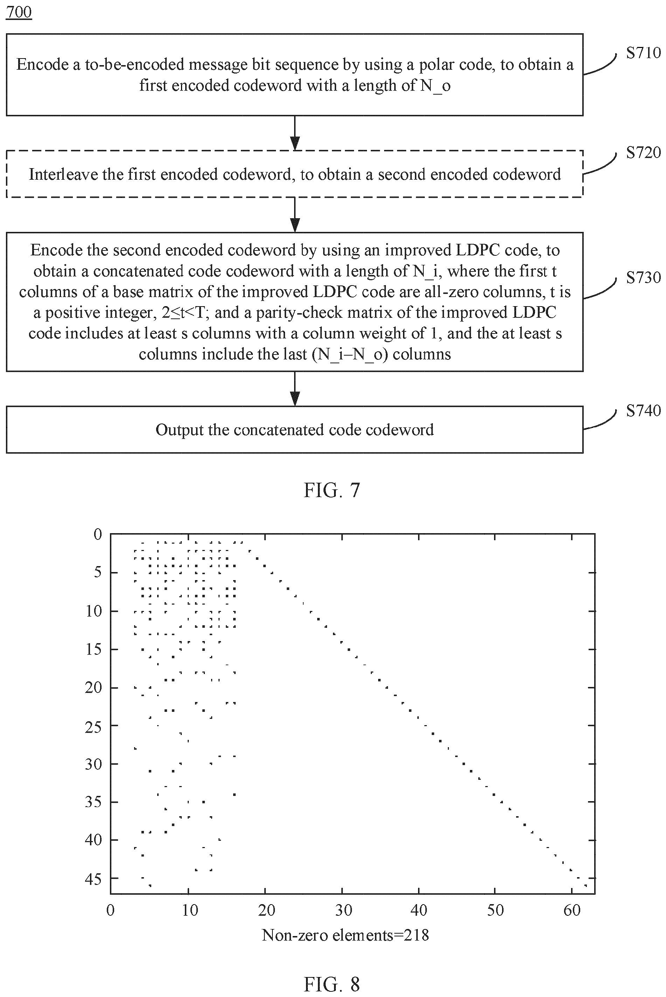

For detailed descriptions of S510, refer to further descriptions in FIG. 6 and FIG. 7.

S520: The transmitting end sends the concatenated code codeword.

A receiving end receives a channel received vector (or referred to as a channel received sequence).

S530: The receiving end decodes the channel received vector by using a soft information iterative decoding scheme, to obtain an estimated sequence from decoding.

The soft information iterative decoding scheme used in this application is a soft information iterative decoding algorithm combining a soft SCL decoding algorithm and a belief propagation (belief propagation, BP) decoding algorithm, and has low decoding complexity.

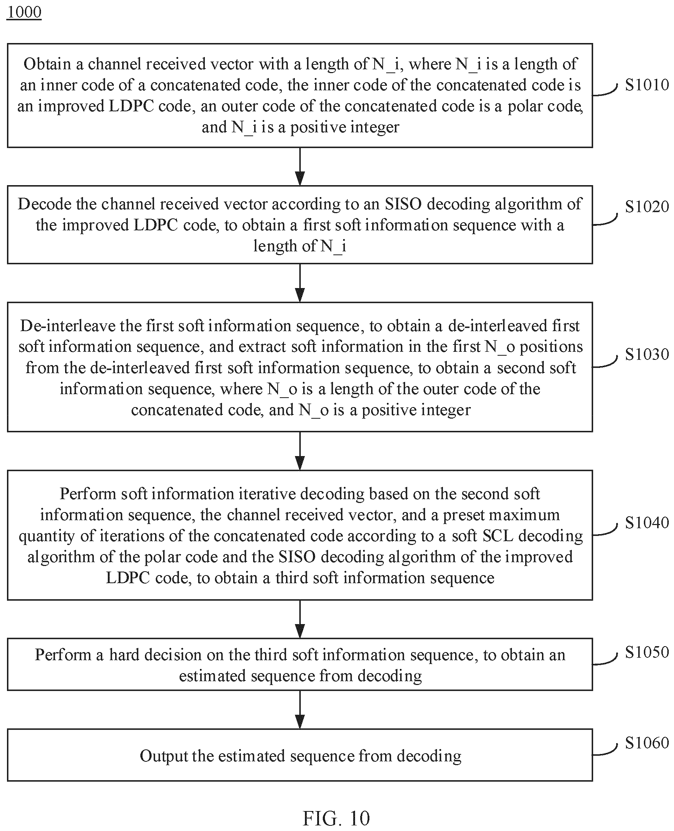

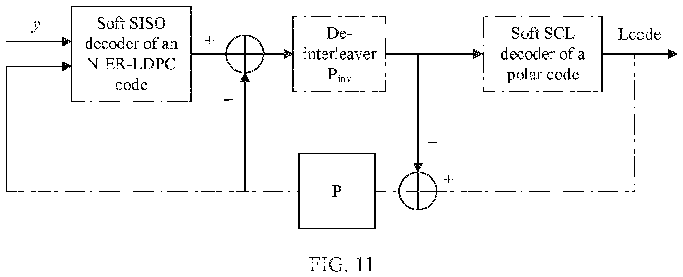

For detailed descriptions of S530, refer to the detailed descriptions in FIG. 10 and FIG. 11.

FIG. 6 is a diagram of an encoding process of a concatenated code according to this application. As shown in FIG. 6, a main process of concatenated encoding at a transmitting end may be as follows:

(1) A to-be-encoded message bit sequence of a given concatenated code is $u =(u\_1, u\_2, ..., u\_K)$, where K is a positive integer;

(2) add $r$ CRC check bits to the to-be-encoded message bit sequence $u$, to obtain a sequence with a length of $K+r$, where r is a positive integer;

(3) encode the sequence with a length of $K+r$ by using a polar code, to obtain an inner code with a code length of N_o and a quantity K_o of message bits, that is, to obtain a polar code codeword C_o, where K_o=$K+r$, and N_o is a positive integer;

(4) interleave C_o to obtain an interleaved codeword P(C_o), where a length of an interleaver is N_o; and

(5) perform N-ER-LDPC encoding on the codeword P(C_o), to obtain a concatenated codeword with a quantity K_i of message bits and a length of N_i, where K_i=N_o, and N_i is a positive integer.

It should be noted that the interleaving on the polar code codeword C_o is an optional step. That is, N-ER-LDPC encoding may be directly performed on the polar code codeword C_o without interleaving.

FIG. 7 is a diagram of an encoding process at a transmitting end according to this application.

S710: The transmitting end encodes a to-be-encoded message bit sequence by using a polar code, to obtain a first encoded codeword with a length of N_o.

The to-be-encoded message bit sequence may also be referred to as an information bit sequence.

It should be understood that, after S710, the transmitting end completes outer-code encoding of a concatenated code, and the first encoded codeword may be referred to as a polar codeword or an outer-code codeword.

Optionally, the method 700 further includes S720.

S720: The transmitting end interleaves the first encoded codeword, to obtain a second encoded codeword.

The interleaving in S720 includes outer interleaving and inner interleaving. The outer interleaving may be implemented by an outer interleaver, and the inner interleaving may be implemented by an inner interleaver.

Specifically, after the outer interleaving, indexes corresponding to R frozen bits of the first encoded codeword are mapped to R rows of a generator matrix of an improved LDPC code. Row weights of the R rows are less than or equal to a row weight of a row other than the R rows in the generator matrix. Indexes corresponding to I message bits of the first encoded codeword are mapped to I rows of the generator matrix of the improved LDPC code. Row weights of the I rows are greater than or equal to a row weight of a row other than the I rows in the generator matrix. R=N_o-K_o, and I=K_o. A quantity of non-zero elements included in each column in the generator matrix of the improved LDPC code is referred to as a column weight.

In other words, if row indexes of the generator matrix form a set, and row indexes in the set are sorted in ascending order of row weights. In the outer interleaving, the indexes corresponding to the R frozen bits of the first encoded codeword are mapped to R rows corresponding to the first R row indexes in the set, and the indexes corresponding to the message bits of the first encoded codeword are mapped to I rows corresponding to the last I row indexes in the set.

For example, an index set corresponding to the frozen bits of the first encoded codeword is denoted as a set F={$f_1$, $f_2$, ..., $f_R$}, and the set F is sorted in a natural order, where $f_1$ has a smallest value, and $f_R$ has a largest value. An index set corresponding to the message bits of the first encoded codeword is denoted as a set J={$j_1$,$j_2$, ..., $j_I$}. A row index (or row index) set of the generator matrix G of the improved LDPC code is denoted as a set S={$j_1$, $j_2$, ..., $j_{N\_o}$}, and row indexes in the set S are sorted in ascending order of row weights. Further, after the outer interleaving, the set F is mapped to the first R elements of the set S, that is, F->S[1:R], and the set J is mapped to the last I elements of the set S, that is, J->S[(N_o-I+1):N_o].

The inner interleaving includes: interleaving a mapping relationship between the indexes corresponding to the R frozen bits and the R rows, and interleaving a mapping relationship between the indexes corresponding to the I message bits and the I rows.

Optionally, the inner interleaving may be any one of the following:

(a) random interleaving;
(b) quadratic interleaving: j->(a*j*(j-1)/2 mod L)+1, where L is a length of the inner interleaver, a is any odd number, and j=1, 2, 3, ..., L. For example, a=3, L=8, and a sequence [1 4 2 3 7 6 8 5] is obtained after quadratic interleaving is performed on a sequence [1 2 3 4 5 6 7 8]; and
(c) cyclic interleaving: j->(b*j+r) mod L+1, where b is an integer co-prime to L, L is a length of the inner interleaver, and r is any integer. For example, r=6, b=7, and a sequence [6 5 4 3 2 1 8 7] is obtained after cyclic interleaving is performed on the sequence [1 2 3 4 5 6 7 8].

S730: The transmitting end encodes the second encoded codeword by using the improved LDPC code, to obtain a concatenated code codeword with a length of N_i.

It may be understood that, if S720 is performed in the method 700, the second encoded codeword is obtained by interleaving the first encoded codeword. If S720 is not performed in the method 700, the second encoded codeword is the same as the first encoded codeword.

The improved LDPC code is obtained based on a base matrix and a lifting matrix of the improved LDPC code.

The base matrix of the improved LDPC code has at least one of the following features:

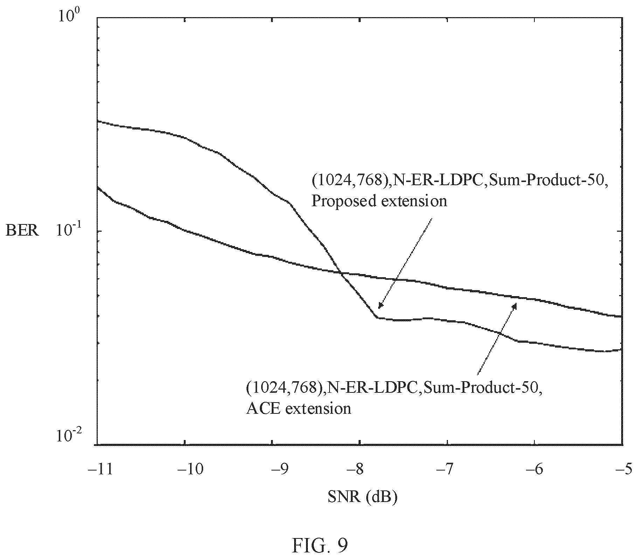

(1) The first t columns are all-zero columns, t is a positive integer, 2≤t<T, T is a ratio of N_o to p, that is, T=N_o/p, p is a multiple by which the base matrix needs to be extended, and p may also be referred to as a lifting size. Both N_o and p are divisible by 2. For example, when t=2, a base graph corresponding to the base matrix of the improved LDPC code is shown in FIG. 8. It may be understood that the all-zero column helps ensure concatenated encoding performance. BER performance in a position corresponding to the all-zero column does not change, a slope of a BER curve is smoother, and a dynamic range of a corresponding signal-to-noise ratio (signal noise ratio, SNR) is wider. FIG. 9 is a diagram of BER performance of the improved LDPC code used as the inner code according to an embodiment of this application. As shown in FIG. 9, because the improved LDPC code has an all-zero column, a corresponding SNR range is wider when a BER is equal to 0.1.
(2) The base matrix includes at least s' columns with a column weight of 1, where s' is a positive integer. The at least s' columns include the last s" columns of the base matrix, and s" is a ratio of a difference obtained by subtracting N_o from N_i to p, that is, s"=(N_i-N_o)/p.

A parity-check matrix of the improved LDPC code has at least one of the following features:

(1) The parity-check matrix of the improved LDPC code includes at least s columns with a column weight of 1, where s is a positive integer. The at least s columns include the last (N_i-N_o) columns of the parity-check matrix. It may be understood that a column with a column weight of 1 corresponds to an identity matrix in the parity-check matrix of the improved LDPC code. This feature can ensure that the improved LDPC code has nesting performance, so that the concatenated encoding provided in this embodiment of this application can meet a rate compatibility requirement.

(2) A difference obtained by subtracting a quantity of rows from a quantity of columns of the parity-check matrix of the improved LDPC code is divisible by 2. It may be understood that an outer code of the improved LDPC code is a polar code with a mother code length, and the length of the polar code is a power of 2. That is, N_o is divisible by 2. In addition, because the difference obtained by subtracting the quantity of rows from the quantity of columns of the parity-check matrix of the improved LDPC code is N_o, the difference obtained by subtracting the quantity of rows from the quantity of columns of the parity-check matrix of the improved LDPC code is divisible by 2.

(3) Column weight distribution of the parity-check matrix of the improved LDPC code meets Table 1.

Table 1

| Code rate of the improved LDPC code | Column weight of the parity-check matrix | Column degree distribution | | | Sparseness |
|---|---|---|---|---|---|
| 4/20 | 0 1 2 3 4 | 0.1000<br>0.2500 | 0.2000<br>0.1500 | 0.3000 | 0.5375 |
| 10/26 | 0 1 4 5 6 7 8 | 0.0769<br>0.0769<br>0.0385 | 0.3846<br>0.1923 | 0.0385<br>0.1923 | 0.1745 |
| 20/36 | 0 1 7 8 9 10 11 | 0.0556<br>0.1389<br>0.1111 | 0.5556<br>0.0556 | 0.0278<br>0.0556 | 0.2069 |
| 30/46 | 0 1 8 9 10 11 12 13 | 0.0435<br>0.0870<br>0.0870 | 0.6522<br>0.0435<br>0.0217 | 0.0217<br>0.0435 | 0.1283 |
| 46/62 | 0 1 9 10 11 12 13 14 15 16 | 0.0323<br>0.0161<br>0.0484<br>0.0161 | 0.7419<br>0.0484<br>0.0161 | 0.0161<br>0.0484<br>0.0161 | 0.0764 |

The base matrix of the improved LDPC code may be extended by using a special lifting method to extend a code length, to obtain the parity-check matrix of the improved LDPC code. The following describes a design of the lifting matrix (lifting matrix) and steps of obtaining the parity-check matrix of the improved LDPC code based on the lifting matrix and the base matrix of the improved LDPC code.

It is assumed that the base matrix of the LDPC code is a matrix with m rows and n columns, and the base matrix needs to be extended by p times, to obtain the parity-check matrix with a dimension equal to $mp*np(m<n)$, where both m and n are positive integers. The steps of obtaining the parity-check matrix of the improved LDPC code are as follows:

(1) Construct a row vector with a size of m and a column vector with a size of v, where any two elements in the row vector are different, any two elements in the column vector are different, both m and v are less than or equal to p, v is equal to n or $v=(n-t)$, and t is equal to a quantity of all-zero columns in the base matrix of the LDPC code.

For example, the constructed row vector $\mathbf{C}_{rows}$ may be represented as $C_{rows}=(r_1, r_2, ..., r_m)$. Any two elements in $\mathbf{C}_{rows}$ are unequal. That is, $r_i \neq r_{i'}$, where $r_i$ represents the $i^{th}$ element in the row vector $C_{rows}$, $r_{i'}$ represents the $i'^{th}$ element in the row vector $C_{rows}$, $1 \leq i \leq m$, $1 \leq i' \leq m$, and $i \neq i'$.

The constructed column vector $C_{cols}$ may be represented as $C_{cols}=(c_1, c_2, ..., c_v)$. Any two elements in the column vector $\mathbf{C}_{cols}$ are unequal. That is, $c_{j'} \neq c_j$, where $c_{j'}$ is the $j'^{th}$ element in the column vector $\mathbf{C}_{cols}$, $c_j$ is the $j^{th}$ element in the column vector $C_{cols}$, $1 \leq j \leq v$, $1 \leq j' \leq v$, and $j' \neq j$.

(2) Obtain the lifting matrix based on the row vector and the column vector.

For example, based on the row vector and the column vector, the constructed lifting matrix $\mathbf{M}$ may be represented as $\mathbf{M}(i, j)=r_i*c_j \bmod p$, where mod is a remainder operation, $\mathbf{M}(i, j)$ is an element in the $i^{th}$ row and the $j^{th}$ column in the lifting

matrix, and $r_i*c_j$ indicates that $r_i$ is multiplied by $c_j$.

(3) Obtain an updated base matrix based on the lifting matrix and the base matrix.

If v=n, the updated base matrix $\mathbf{H}_m$ obtained based on the lifting matrix and the base matrix may be represented as: $\mathbf{H}_m=\mathbf{H}_{opt}\odot\mathbf{M}$. That is, an element $\mathbf{H}_m(i, j)$ in the updated base matrix is equal to a product of an element $\mathbf{H}_{opt}(i, j)$ in the base matrix and an element $\mathbf{M}(i, j)$ in the lifting matrix. $\mathbf{H}_m(i, j)$ is an element in the ith row and the jth column in the updated lifting matrix, $\mathbf{H}_{opt}$ represents the base matrix, and $\mathbf{H}_{opt}(i, j)$ is an element in the ith row and the jth column in the base matrix. $\mathbf{H}_m$ may be referred to as a Hadamard product or a basic product of $\mathbf{H}_{opt}$ and $\mathbf{M}$.

If v=n-t, the obtaining an updated base matrix based on the lifting matrix and the base matrix includes: extracting a non-zero column in the base matrix $\mathbf{H}_{opt}$, to obtain a matrix $\mathbf{H}_{opt2}$; and obtaining the updated base matrix $\mathbf{H}_m$ based on the matrix $\mathbf{H}_{opt2}$ and the lifting matrix $\mathbf{M}$. The updated base matrix $\mathbf{H}_m$ may be represented as: $\mathbf{H}_m=\mathbf{H}_{opt2}\odot\mathbf{M}$. That is, an element $\mathbf{H}_m(i, j)$ in the updated base matrix is equal to a product of an element $\mathbf{H}_{opt2}(i, j)$ in the matrix $\mathbf{H}_{opt2}$ and an element $\mathbf{M}$ (i, j) in the lifting matrix. $\mathbf{H}_{opt2}(i, j)$ is an element in the ith row and the jth column in the matrix $\mathbf{H}_{opt2}$. $\mathbf{H}_m$ may be referred to as a Hadamard product or a basic product of $\mathbf{H}_{opt2}$ and $\mathbf{M}$.

(4) Obtain the parity-check matrix of the improved LDPC code based on the updated base matrix.

If v=n, the parity-check matrix of the improved LDPC code is obtained by extending the updated base matrix by p times.

For example, an expression of the updated base matrix may be as follows:

$$\mathbf{H}_m = \begin{bmatrix} a_{1,1} & a_{1,2} & \cdots & a_{1,v} \\ a_{2,1} & a_{2,2} & \cdots & a_{2,v} \\ \vdots & \vdots & \ddots & \vdots \\ a_{m,1} & a_{m,2} & \cdots & a_{m,v} \end{bmatrix}.$$

An expression of the parity-check matrix of the improved LDPC code obtained by extending the updated base matrix by p times may be as follows:

$$\mathbf{H} = \begin{bmatrix} \mathbf{I}(a_{1,1}) & \mathbf{I}(a_{1,2}) & \cdots & \mathbf{I}(a_{1,v}) \\ \mathbf{I}(a_{2,1}) & \mathbf{I}(a_{2,2}) & \cdots & \mathbf{I}(a_{2,v}) \\ \vdots & \vdots & \ddots & \vdots \\ \mathbf{I}(a_{m,1}) & \mathbf{I}(a_{m,2}) & \cdots & \mathbf{I}(a_{m,v}) \end{bmatrix}.$$

Each element $\mathbf{I}(a_{i,j})$ ($1\le i\le m,\ 1\le j\le v$) in the parity-check matrix $\mathbf{H}$ may be a zero matrix or a cyclic shift matrix. If $a_{i,j}$ is greater than or equal to 0, a cyclic shift matrix (for example, $\mathbf{I}(a_{i,j})$) may be obtained by cyclically shifting an identity matrix with a dimension of $p\times p$ by $a_{i,j}$ positions. Therefore, $a_{i,j}$ is also referred to as a shift factor of a cyclic shift matrix. A value range of $a_{i,j}$ may be $-1\le a_{i,j}<p$.

If v=n-t, the obtaining the parity-check matrix of the improved LDPC code based on the updated base matrix includes: extending the updated base matrix by P times to obtain an intermediate parity-check matrix; and padding t*p all-zero columns before the 1st column of the intermediate parity-check matrix, to obtain the parity-check matrix of the improved LDPC code.

An expression of the parity-check matrix of the improved LDPC code that is obtained based on the updated base matrix may be as follows:

$$\mathbf{H} = \begin{bmatrix} \mathbf{I}(0) & \mathbf{I}(a_{1,1}) & \mathbf{I}(a_{1,2}) & \cdots & \mathbf{I}(a_{1,v}) \\ \mathbf{I}(0) & \mathbf{I}(a_{2,1}) & \mathbf{I}(a_{2,2}) & \cdots & \mathbf{I}(a_{2,v}) \\ \vdots & \vdots & \vdots & \ddots & \vdots \\ \mathbf{I}(0) & \mathbf{I}(a_{m,1}) & \mathbf{I}(a_{m,2}) & \cdots & \mathbf{I}(a_{m,v}) \end{bmatrix}.$$

An element **I**(0) in the parity-check matrix **H** represents an all-zero matrix with a size of p rows and t*p columns.

It can be learned from the foregoing descriptions that, in the solution provided in this application, the lifting matrix corresponding to the base matrix with a dimension m*n of the improved LDPC code has at least one of the following external features:

(1) The lifting matrix may be obtained by multiplying the following two vectors:

$\mathbf{C}_{rows}(r_1, ..., r_m)$, where $r_i \neq r_{i'}$; and

$\mathbf{C}_{cols}=(c_1, ..., c_v)$, where $c_j \neq c_{j'}$.

(2) Dimensions of the foregoing two vectors are m and v respectively, and any two elements in the vectors do not overlap. For example, two difference sets (difference set) with dimensions 1*m and 1*v are selected.

(3) For any p>max(m, v), a lifting matrix $\mathbf{M}(i, j)=(r_i*c_j) \bmod p$ is constructed.

FIG. 9 is a diagram of a technical effect of the lifting matrix according to this application. In FIG. 9, simulation parameters are N_i=1024 and N_o=768, and a quantity of iterations of a sum product algorithm is 50 (sum-product-50). A proposed extension (proposed extension) solution represents BER performance of the N-ER-LDPC code obtained based on the lifting matrix provided in this application, and an approximated cycle extrinsic message degrees (approximated cycle extrinsic message degrees, ACE) extension (ACE extension) solution represents BER performance of an N-ER-LDPC code obtained based on a lifting matrix designed according to an ACE algorithm. It can be learned that, in an interval in which a BER is less than 0.1, a BER in the solution of this application is greater than a BER in the ACE solution, which means a larger SNR dynamic range.

After the parity-check matrix of the improved LDPC code is obtained, the second encoded codeword may be encoded based on the parity-check matrix of the improved LDPC code, to obtain the concatenated code codeword with a length of N_i.

It should be noted that, if the transmitting end pre-stores the parity-check matrix that is of the improved LDPC code and that is determined according to the foregoing method, the transmitting end may directly encode the second encoded codeword based on the parity-check matrix of the improved LDPC code. In other words, if the transmitting end pre-stores the parity-check matrix that is of the improved LDPC code and that is determined according to the foregoing method, before encoding the second code, the transmitting end does not need to determine the parity-check matrix of the improved LDPC code according to the foregoing method.

S740: The transmitting end outputs the concatenated code codeword.

FIG. 10 is a diagram of a decoding process at a receiving end according to this application.

S1010: The receiving end obtains a channel received vector with a length of N_i.

N_i is a length of an inner code of a concatenated code, the inner code of the concatenated code is an improved LDPC code, an outer code of the concatenated code is a polar code (which is specifically the first encoded codeword), and N_i is a positive integer.

Steps of decoding the channel received vector by the receiving end may include S1020 to S1050.

S1020: The receiving end decodes the channel received vector according to an SISO decoding algorithm of the improved LDPC code, to obtain a first soft information sequence with a length of N_i.

It should be understood that "soft information" or "soft value" in this application is an LLR. For example, that the length of the first soft information sequence is N_i means that the first soft information sequence includes N_i LLRs, and the N_i LLRs are obtained by decoding the channel received vector **y** by using an SISO decoder of the improved LDPC code.

A quantity of iterations of the SISO decoder is recorded as inner_iter.

S1030: The receiving end de-interleaves the first soft information sequence, to obtain a de-interleaved first soft information sequence, and extracts soft information in the first N_o positions from the de-interleaved first soft information sequence, to obtain a second soft information sequence, where N_o is a length of the outer code of the concatenated code, and N_o is a positive integer.

It should be understood that, if the second encoded codeword is obtained by interleaving on the first encoded codeword, in S1030, the receiving end completes de-interleaving of the first soft information sequence, and reads the soft information in the first N_o positions from the de-interleaved first soft information sequence, to obtain a soft information sequence of the polar outer code, that is, obtain the second soft information sequence.

If the second encoded codeword is the same as the first encoded codeword, in S1030, the receiving end directly reads soft information in the first N_o positions from the first soft information sequence, to obtain the soft information sequence of the polar outer code, that is, obtains the second soft information sequence.

S1040: The receiving end performs soft information iterative decoding based on the second soft information sequence, the channel received vector, and a preset maximum quantity of iterations of the concatenated code according to a soft SCL decoding algorithm of the polar code and the SISO decoding algorithm of the improved LDPC code, to obtain a third soft information sequence.

It may be further understood that the SISO decoding algorithm of the improved LDPC code is related to a parity-check matrix of the improved LDPC code described in the method 700. In other words, in S1040, the receiving end performs the SISO decoding algorithm of the improved LDPC code based on the parity-check matrix of the improved LDPC code.

It should be noted that, for a manner of determining the parity-check matrix of the improved LDPC code by the receiving end and a manner of determining the parity-check matrix of the improved LDPC code by the transmitting end, refer to the descriptions in the method 700.

It should be further noted that, if the receiving end pre-stores the parity-check matrix that is of the improved LDPC code and that is determined according to the manner described in the method 700, the receiving end may directly perform the SISO decoding algorithm of the improved LDPC code based on the parity-check matrix of the improved LDPC code. In other words, if the receiving end pre-stores the parity-check matrix that is of the improved LDPC code and that is determined according to the manner described in the method 700, before performing the SISO decoding algorithm of the improved LDPC code, the receiving end does not need to determine the parity-check matrix of the improved LDPC code according to the manner described in the method 700.

In S 1040, the receiving end performs iterative decoding by using the soft information in this application, and after the preset maximum quantity of iterations max_Iter is reached through iterative decoding, a soft SCL decoder outputs the third soft information sequence, that is, a soft value sequence of a decoded sequence.

Specifically, in an example of any two adjacent iteration processes, a process of soft information iterative decoding is as follows:

Soft information iterative decoding is performed for (j-1) times, to obtain the (j-1)$^{th}$ soft information sequence output by the soft SCL decoding algorithm.

A soft information sequence input to the soft SCL decoding algorithm in the (j-1)$^{th}$ soft information iterative decoding process is subtracted from the (j-1)$^{th}$ soft information sequence, to obtain the j$^{th}$ piece of extrinsic information of the SISO decoding algorithm.

A sum of the j$^{th}$ piece of extrinsic information and the channel received vector is used as an input of the SISO decoding algorithm in the j$^{th}$ soft information iterative decoding process, to obtain an output of the SISO decoding algorithm in the j$^{th}$ soft information iteration process.

The sum of the j$^{th}$ piece of extrinsic information and the channel received vector is subtracted from the output of the SISO decoding algorithm in the j$^{th}$ soft information iteration process, to obtain the j$^{th}$ soft information sequence of the soft SCL decoding algorithm.

The j$^{th}$ soft information sequence of the soft SCL decoding algorithm is a soft information sequence output by the soft SCL decoding algorithm in the j$^{th}$ soft information iteration process.

The j$^{th}$ piece of extrinsic information of the SISO decoding algorithm is extrinsic information input to the SISO decoding algorithm in the j$^{th}$ soft information iteration process.

The second soft information sequence is a soft information sequence that is input to the soft SCL decoding algorithm in the 1$^{st}$ soft information iteration process, and the third soft information sequence is a soft information sequence that is output by the soft SCL decoding algorithm in the last soft information iteration process.

$1 < j \leq$ max_Iter, and j is a positive integer.

S1050: The receiving end performs a hard decision on the third soft information sequence, to obtain an estimated sequence from decoding.

S1060: The receiving end outputs the estimated sequence from decoding.

The following describes in detail a process in which the receiving end performs soft information iterative decoding with reference to FIG. 11.

FIG. 11 is a diagram of a soft information iterative decoding scheme at a receiving end according to this application.

As shown in FIG. 11, a process in which a receiving end performs soft information iterative decoding is as follows:

(1) The channel received vector $y=(y\_1, y\_2, ..., y\_N_i)$ is first sent to the SISO decoder for the N-ER-LDPC for decoding. A quantity of iterations of the SISO decoder is inner-iter. An output decoded soft message has a length N_i, and is recorded as a sequence $\boldsymbol{d}=(d\_1, d\_2, ..., d\_N_i)$.

(2) A de-interleaver corresponding to the encoding-side interleaver P is found, that is, P_inv.

(3) The first N_o values of the sequence $\boldsymbol{d}$ with a length of N_i obtained through decoding are extracted, to obtain a soft information sequence $L\_polar=P\_inv(L_{N\text{-ER-LDPC}\_No}=(L\_1, L\_2, ..., L\_{No}))$ of the polar outer code. It should be noted that the first N_o values of the sequence $\boldsymbol{d}$ with a length of N_i include values corresponding to all-zero columns in the parity-check matrix of the N-ER-LDPC code, and soft information of polar code codeword bits corresponding to the all-zero columns is not updated in a large iterative decoding process.

(4) Execute the following loop:
for i=1:max_Iter

(a) [L_out, L_code]=soft_SCL(L_polar, List):

The polar code is decoded by a soft_SCL decoder, to obtain two outputs L_out and L_code. L_out is a message soft value on a U side of the polar code, and L_code is a codeword soft value on a C side of the polar code. The UE side of the polar code represents a message side of the polar code, the message soft value on the U side of the polar code is a soft value corresponding to a message sequence before the polar code is encoded, and the message sequence before the polar code is encoded includes a message bit and a frozen bit. The C side of the polar code represents a codeword side of the polar code, and the codeword soft value on the C side of the polar code is a soft value corresponding to a codeword obtained after the polar code is encoded.

The soft_SCL decoder has two inputs: L_polar and List. L_polar is the soft information sequence of the polar outer code described in step (3), and L_polar is a soft input LLR value of the soft_SCL decoder of the polar code. List is a size of a decoding list, and a value of List is a power of 2, for example, 1, 2, 4, 8, 16, or 32.

(b) Extrinsic information (soft value) sent to an N-ER-LDPC decoder is calculated. A length of the extrinsic information is equal to a length of the channel received vector, and is also N_i bits. Values in N_i-N_o non-system positions are 0, and values in other N_o positions are equal to (P(L_code)-L_polar). That is, values of N_o non-zero elements are equal to a result obtained by subtracting the $1^{st}$ input of the soft_SCL decoder from the $2^{nd}$ output (interleaved) of the soft_SCL decoder. A vector of the extrinsic information is denoted as E=[P(L_code)-L_polar; 0000... 0 (N_i-N_o zeros in total)].

(c) SISO decoding is performed on the N-ER-LDPC again. This time, in addition to the channel received vector y=(y_1, y_2, ..., y_Ni) with a length of N_i, the vector E of the extrinsic information obtained in step (b) needs to be added to the input of the SISO decoder. That is, the input L_d of the SISO decoder is represented as L_d=soft LDPC decode(y+E, inner_iter).

(d) Soft values at the first N_o positions of the N-ER-LDPC are extracted, and then an input of the N-ER-LDPC decoder is subtracted, to generate an input of a next round of polar soft SCL decoding.

In conclusion, two decoders in the soft information iterative decoding process are the soft SCL decoder of the polar code (that is, the outer code of the concatenated code) and the decoder of the N-ER-LDPC code (that is, the inner code of the concatenated code).

It should be noted that the de-interleaving in the foregoing decoding process is an optional step. If the encoding process does not include the interleaving step, the decoding process does not include the de-interleaving step.

In this embodiment of this application, because the first t columns of the base matrix of the improved LDPC code are all-zero columns, in the method provided in this embodiment of this application, in a large iterative decoding process, a soft value of the polar outer code and a soft value of the improved LDPC code are not updated at the all-zero columns, and update of a part of soft values can improve performance of large iterative decoding.

In addition, because the column weights of the last (N_i-N_o) columns of the parity-check matrix of the improved LDPC code are 1, the method provided in this embodiment of this application has low encoding complexity, and can implement rate compatibility.

To verify beneficial effects of the improved LDPC code, performance of the encoding and decoding method of a concatenated code provided in embodiments of this application is tested and compared with that of an NR LDPC code when a simulation channel is an additive white Gaussian noise (additive white Gaussian noise, AWG) channel and a modulation scheme is binary phase shift keying (binary phase shift key, BPSK). In the method provided in embodiments of this application, the outer-code encoding scheme uses a polar code concatenated with 2-bit CRC, and a construction manner of the polar code is density evolution. In the decoders, the polar outer code decoder uses soft SCL decoding with a list length of 4, and the inner code decoder uses BP decoding of 10 iterations. The first 2p columns of the parity-check matrix of the improved LDPC code are punctured, and a quantity of large iterations in concatenated code decoding is 10. In comparison, the performance of the NR LDPC code in BP decoding is tested for 50 and 100 iterations.

Simulation parameters of the concatenated code provided in embodiments of this application are shown in Table 2. $r_{LDPC}$ is a row quantity of the parity-check matrix the improved LDPC, $n_{LDPC}$ is a column quantity of the parity-check matrix of the improved LDPC, p is a lifting size, PN is a puncturing position of the improved LDPC code, $R_{N-ER-LDPC}$ is a code rate of the inner code, $K_{LDPC}$ is a quantity of message bits of the inner code, $R_{polar}$ is a code rate of the polar outer code (that is, $K_{polar}/K_{LDPC}$), CRC is a length of an outer code CRC, $K_{polar}$ is a length (excluding a CRC) of a payload message bit of the polar outer code, $N_{CC}$ is a code length of the entire concatenated code, and $R_{CC}$ is a code rate of the entire concatenated code.

Table 2

| $r_{LDPC}$ | $n_{LDPC}$ | p | PN | $R_{N-ER-LDPC}$ | $K_{LDPC}$ | $R_{polar}$ | CRC | $K_{polar}$+CRC | $N_{CC}$ | $R_{CC}$ |
|---|---|---|---|---|---|---|---|---|---|---|
| 31 | 47 | 64 | 1:2*p | 0.3556 | 1024 | 15/16 | 2 | 960+2 | 2880 | 1/3 |
| 31 | 47 | 128 | 1:2*p | 0.3556 | 2048 | 15/16 | 2 | 1920+2 | 5760 | |
| 31 | 47 | 256 | 1:2*p | 0.3556 | 4096 | 15/16 | 2 | 3840+2 | 11520 | |
| 15 | 31 | 64 | 1:2*p | 0.5517 | 1024 | 29/32 | 2 | 928+2 | 1856 | 1/2 |
| 15 | 31 | 128 | 1:2*p | 0.5517 | 2048 | 29/32 | 2 | 1856+2 | 3712 | |
| 15 | 31 | 256 | 1:2*p | 0.5517 | 4096 | 29/32 | 2 | 3712+2 | 7424 | |
| 6 | 22 | 64 | 1:2*p | 0.8 | 1024 | 15/16 | 2 | 960+2 | 1280 | 3/4 |
| 6 | 22 | 128 | 1:2*p | 0.8 | 2048 | 15/16 | 2 | 1920+2 | 2560 | |
| 6 | 22 | 256 | 1:2*p | 0.8 | 4096 | 15/16 | 2 | 3840+2 | 5120 | |

Simulation parameters of the NR LDPC code are shown in Table 3. $K_{NR-LDPC}$ is a quantity of message bits of the NR LDPC code, and $R_{NR-LDPC}$ is a code rate of the NR LDPC code.

Table 3

| Baseline 1: 50 BP iterations | | Baseline 2: 100 BP iterations | |
|---|---|---|---|
| $K_{NR-LDPC}$ | $R_{NR-LDPC}$ | $K_{NR-LDPC}$ | $R_{NR-LDPC}$ |
| 1024 | | 960 | |
| 2048 | 1/3 | 1920 | 1/3 |
| 4096 | | 3840 | |
| 1024 | | 928 | |
| 2048 | 1/2 | 1856 | 1/2 |
| 4096 | | 3712 | |
| 1024 | | 960 | |
| 2048 | 3/4 | 1920 | 3/4 |
| 4096 | | 3840 | |

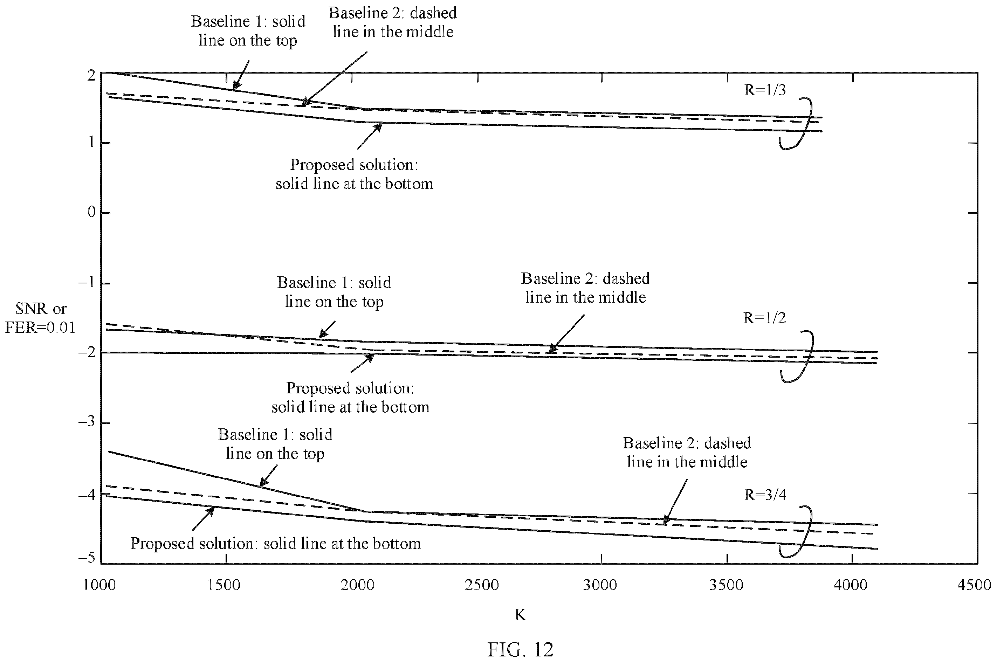

FIG. 12 shows a comparison between performance of the concatenated code provided in this embodiment of this application and performance of the NR LDPC code. A horizontal axis is a quantity of message bits, and a vertical axis is an SNR required when a bit error rate is equal to 0.01. A smaller SNR required when the bit error rate is equal to 0.01 indicates better error correction performance of a codeword. It can be learned from FIG. 12 that the solution provided in this application can meet a rate compatibility requirement, and has better error correction performance than the existing NR LDPC code in different code lengths and code rates.

The foregoing describes the encoding and decoding method of a concatenated code provided in this application. The following describes a communication apparatus provided in this application.

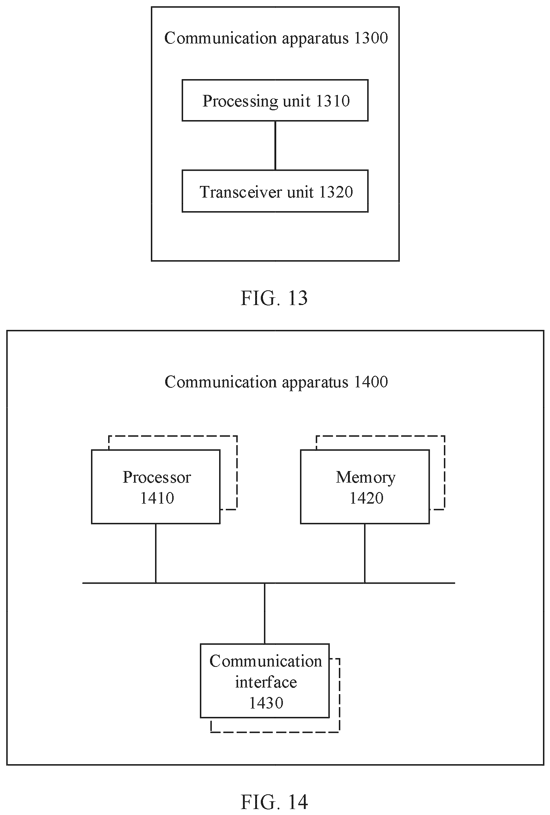

FIG. 13 is a block diagram of a communication apparatus according to this application. As shown in FIG. 13, the communication apparatus 1300 includes a processing unit 1310 and a transceiver unit 1320.

Optionally, the communication apparatus 1300 may correspond to the transmitting end in the method embodiments of this application. In this case, the units of the communication apparatus 1300 are configured to implement the following functions:

The processing unit 1310 is configured to: encode a to-be-encoded message bit sequence by using a polar code, to obtain a first encoded codeword with a length of N_o, where N_o is a positive integer; and encode a second encoded codeword by using an improved LDPC code, to obtain a concatenated code codeword with a length of N_i, where the second encoded codeword is determined based on the first encoded codeword, and N_i is a positive integer. The first t columns of a base matrix of the improved LDPC code are all-zero columns, t is a positive integer, 2≤t<T, T is equal to a ratio of N_o to p, p is a multiple by which the base matrix needs to be extended, and p is a positive integer. A parity-check matrix of the improved LDPC code includes at least s columns with a column weight of 1, and the at least s columns include the last (N_i-N_o) columns.

The transceiver unit 1320 is configured to output the concatenated code codeword.

Optionally, the communication apparatus 1300 may correspond to the receiving end in the method embodiments of this application. In this case, the units of the communication apparatus 1300 are configured to implement the following functions:

The transceiver unit 1320 is configured to obtain a channel received vector with a length of $N\_i$, where $N\_i$ is a length of an inner code of a concatenated code, the inner code of the concatenated code is an improved LDPC code, an outer code of the concatenated code is a polar code, and $N\_i$ is a positive integer.

The processing unit 1310 is configured to: decode the channel received vector according to an SISO decoding algorithm of the improved LDPC code, to obtain a first soft information sequence with a length of $N\_i$, where the SISO decoding algorithm is related to a parity-check matrix of the improved LDPC code; the first t columns of a base matrix of the improved LDPC code are all-zero columns, t is a positive integer, $2 \leq t < T$, T is a ratio of $N\_o$ to p, p is a multiple by which the base matrix needs to be extended, and p is a positive integer; and the parity-check matrix of the improved LDPC code includes at least s columns with a column weight of 1, and the at least s columns include the last $(N\_i\text{-}N\_o)$ columns; perform soft information iterative decoding based on the second soft information sequence, the channel received vector, and a preset maximum quantity of iterations of the concatenated code according to a soft SCL decoding algorithm of the polar code and the SISO decoding algorithm of the improved LDPC code, to obtain a third soft information sequence, where the second soft information sequence is determined based on the first soft information sequence; and perform a hard decision on the third soft information sequence to obtain an estimated sequence.

The transceiver unit 1320 is configured to output the estimated sequence.

In embodiments in which the communication apparatus 1300 corresponds to the transmitting end, the processing unit 1310 is configured to perform processing and/or operations implemented inside the transmitting end in addition to sending and receiving actions. The transceiver unit 1320 is configured to perform a receiving (or inputting) action of the transmitting end, and/or configured to perform a sending (or outputting) action of the transmitting end.

For example, in FIG. 5, the processing unit 1310 is configured to perform S510, and the transceiver unit 1320 is configured to perform S520.

For another example, in FIG. 7, the processing unit 1310 is configured to perform S710 to S730, and the transceiver unit 1320 is configured to perform S740.

In embodiments in which the communication apparatus 1300 corresponds to the receiving end, the processing unit 1310 is configured to perform processing and/or operations implemented inside the receiving end in addition to sending and receiving actions. The transceiver unit 1320 is configured to perform a receiving (or inputting) action of the receiving end, and/or configured to perform a sending (or outputting) action of the receiving end.

For example, in FIG. 5, the processing unit 1310 is configured to perform S530.

For another example, in FIG. 10, the transceiver unit 1320 is configured to perform S1010, the processing unit 1320 is configured to perform S1020 to S1050, and the transceiver unit 1320 is configured to perform S1060.

FIG. 14 is a diagram of a structure of a communication apparatus according to this application. As shown in FIG. 14, the communication apparatus 1400 includes: one or more processors 1410, one or more memories 1420, and one or more communication interfaces 1430. The processor 1410 is configured to control the communication interface 1430 to receive and transmit signals. The memory 1420 is configured to store a computer program. The processor 1410 is configured to invoke the computer program from the memory 1420 and run the computer program, so that the communication apparatus 1400 performs processing performed by the transmitting end or the receiving end in the method embodiments of this application.

For example, the processor 1410 may have a function of the processing unit 1310 shown in FIG. 13, and the communication interface 1430 may have a function of the transceiver unit 1320 shown in FIG. 13. Specifically, the processor 1410 may be configured to perform processing or operations performed inside the communication apparatus, and the communication interface 1430 is configured to perform a sending and/or receiving operation performed by the communication apparatus.

In FIG. 14, a dashed-line box behind a component (for example, the processor, the memory, or the communication interface) indicates that there may be at least one component.

Optionally, the memory and the processor in the foregoing apparatus embodiments may be physically independent units, or the memory and the processor may be integrated together. This is not limited in this specification.

In addition, this application further provides a computer-readable storage medium. The computer-readable storage medium stores computer instructions, and when the computer instructions are run on a computer, operations and/or processing performed by the transmitting end in the method embodiments of this application are performed.

This application further provides a computer-readable storage medium. The computer-readable storage medium stores computer instructions, and when the computer instructions are run on a computer, operations and/or processing performed by the receiving end in the method embodiments of this application are performed.

In addition, this application further provides a computer program product. The computer program product includes computer program code or instructions, and when the computer program code or the instructions are run on a computer, operations and/or processing performed by the transmitting end in the method embodiments of this application are performed.

This application further provides a computer program product. The computer program product includes computer program code or instructions, and when the computer program code or the instructions are run on a computer, operations and/or processing performed by the receiving end in the method embodiments of this application are performed.

In addition, this application further provides a chip. The chip includes a processor, a memory configured to store a computer program is disposed independent of the chip, and the processor is configured to execute the computer program stored in the memory, to enable an apparatus in which the chip is installed to perform operations and/or processing performed by the transmitting end in any method embodiment.

Further, the chip may include a communication interface. The communication interface may be an input/output interface, an interface circuit, or the like. Further, the chip may include the memory.

This application further provides a chip. The chip includes a processor, a memory configured to store a computer program is disposed independent of the chip, and the processor is configured to execute the computer program stored in the memory, to enable an apparatus in which the chip is installed to perform operations and/or processing performed by the receiving end in any method embodiment.

Further, the chip may include a communication interface. The communication interface may be an input/output interface, an interface circuit, or the like. Further, the chip may include the memory.

Optionally, there may be one or more processors, there may be one or more memories, and there may be one or more memories.

**In** addition, this application further provides a communication apparatus (for example, a chip or a chip system), including a processor and a communication interface. According to an operation and/or processing performed by the transmitting end in any one of the foregoing method embodiments, the communication interface is configured to receive (or referred to as input) a to-be-encoded message bit, and the processor encodes the to-be-encoded message bit. Optionally, the communication interface is further configured to send (or referred to as an output) data and/or information processed by the processor, for example, send a concatenated code codeword.

This application further provides a communication apparatus (for example, a chip or a chip system), including a processor and a communication interface. According to an operation and/or processing performed by the receiving end in any one of the foregoing method embodiments, the communication interface is configured to receive (or referred to as input) a channel received vector, and the processor is configured to decode the channel received vector. Optionally, the communication interface is further configured to send (or referred to as output) an estimated sequence from decoding.

In addition, this application further provides a communication apparatus, including at least one processor. The at least one processor is coupled to at least one memory, and the at least one processor is configured to execute a computer program or instructions stored in the at least one memory, to enable the communication apparatus to perform operations and/or processing performed by the transmitting end in any method embodiment.

This application further provides a communication apparatus, including at least one processor. The at least one processor is coupled to at least one memory, and the at least one processor is configured to execute a computer program or instructions stored in the at least one memory, to enable the communication apparatus to perform operations and/or processing performed by the receiving end in any method embodiment.

In addition, this application further provides a communication system, including the transmitting end and the receiving end in the method embodiments of this application.

The memory in this embodiment of this application may be a volatile memory or a non-volatile memory, or may include both a volatile memory and a non-volatile memory. The non-volatile memory may be a read-only memory (read-only memory, ROM), a programmable read-only memory (programmable ROM, PROM), an erasable programmable read-only memory (erasable PROM, EPROM), an electrically erasable programmable read-only memory (electrically EPROM, EEPROM), or a flash memory. The volatile memory may be a random access memory (random access memory, RAM), and is used as an external cache. Through example but not limitative description, RAMs in many forms are available, such as a static random access memory (static RAM, SRAM), a dynamic random access memory (dynamic RAM, DRAM), a synchronous dynamic random access memory (synchronous DRAM, SDRAM), a double data rate synchronous dynamic random access memory (double data rate SDRAM, DDR SDRAM), an enhanced synchronous dynamic random access memory (enhanced SDRAM, ESDRAM), a synchlink dynamic random access memory (synchlink DRAM, SLDRAM), and a direct rambus random access memory (direct rambus RAM, DRRAM). It should be noted that the memory of the system and method described in this specification includes but is not limited to these and any memory of another proper type.

All or some of the methods provided in the foregoing embodiments may be implemented by using software, hardware, firmware, or any combination thereof. When software is used to implement the embodiments, all or a part of the embodiments may be implemented in a form of a computer program product. The computer program product may include one or more computer instructions. When the computer program instructions are loaded and executed on the computer, the procedure or functions according to embodiments of this application are all or partially generated. The computer may be a general-purpose computer, a dedicated computer, a computer network, or other programmable apparatuses. The computer instructions may be stored in a computer-readable storage medium or may be transmitted from a computer-readable storage medium to another computer-readable storage medium. For example, the computer instructions may be transmitted from a website, computer, server, or data center to another website, computer, server, or data center in a wired (for example, a coaxial cable, an optical fiber, or a digital subscriber line (digital subscriber line, DSL)) or wireless (for example, infrared, radio, or microwave) manner. The computer-readable storage medium may be any usable medium accessible by the computer, or a data storage device, for example, a server or a data center, integrating one or more usable media.

To clearly describe the technical solutions of embodiments of this application, numbers such as "first" and "second" are used in embodiments of this application to distinguish between same items or similar items that provide basically same functions. For example, first information and second information are merely used to distinguish between different information, and do not limit a sending/receiving sequence of the first information and the second information. A person skilled in the art may understand that the numbers such as "first" and "second" do not limit the number and an execution sequence, and the words such as "first" and "second" do not necessarily indicate a definite difference.

In embodiments of this application, the "message bit" and the "information bit" are sometimes replaced for use. For example, a message bit of the polar outer code may also be represented as an information bit of the polar outer code. In addition, $N\_o$ and $N_o$ may be used alternatively, and $N\_i$ and $N_i$ may be used alternatively. There are some similar replacement expressions in the specification, and details are not described one by one.

In embodiments of this application, "at least one" means one or more, and "a plurality of" means two or more. The term "and/or" describes an association relationship between associated objects, and represents that three relationships may exist. For example, A and/or B may represent the following cases: Only A exists, both A and B exist, and only B exists, where A and B may be singular or plural. The character "/" generally indicates an "or" relationship between the associated objects.

A person of ordinary skill in the art may be aware that, in combination with the examples described in embodiments disclosed in this specification, units and algorithm steps may be implemented by electronic hardware or a combination of computer software and electronic hardware. Whether the functions are performed by hardware or software depends on particular applications and design constraint conditions of the technical solutions. A person skilled in the art may use different methods to implement the described functions for each particular application, but it should not be considered that the implementation goes beyond the scope of this application.

It may be clearly understood by a person skilled in the art that, for the purpose of convenient and brief description, for a detailed working process of the foregoing system, apparatus, and unit, refer to a corresponding process in the foregoing method embodiments. Details are not described herein again.

In the several embodiments provided in this application, it should be understood that the disclosed system, apparatus and method may be implemented in other manners. For example, the described apparatus embodiments are merely examples. For example, division into the units is merely logical function division. There may be another division manner during actual implementation. For example, a plurality of units or components may be combined or integrated into another system, or some features may be ignored or not performed. In addition, the displayed or discussed mutual couplings or direct couplings or communication connections may be implemented by using some interfaces. The indirect couplings or communication connections between the apparatuses or units may be implemented in electronic, mechanical, or other forms.

The units described as separate parts may or may not be physically separate, and parts displayed as units may or may not be physical units, may be located in one position, or may be distributed on a plurality of network units. Some or all of the units may be selected based on actual requirements to achieve the objectives of the solutions of embodiments.

In addition, functional units in embodiments of this application may be integrated into one processing unit, each of the units may exist alone physically, or two or more units are integrated into one unit.

In addition, functional units in embodiments of this application may be integrated into one processing unit, each of the units may exist alone physically, or two or more units are integrated into one unit.

When the functions are implemented in the form of a software functional unit and sold or used as an independent product, the functions may be stored in a computer-readable storage medium. Based on such an understanding, the technical solutions of this application essentially, or the part contributing to the current technology, or some of the technical solutions may be implemented in a form of a software product. The computer software product is stored in a storage medium, and includes several instructions for indicating a computer device (which may be a personal computer, a server, or a network device) to perform all or a part of the steps of the methods described in embodiments of this application. The foregoing storage medium includes any medium that can store program code, such as a USB flash drive, a removable hard disk, a read-only memory (Read-Only Memory, ROM), a random access memory (Random Access Memory, RAM), a magnetic disk, or an optical disc.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

**Claims**

1. An encoding method of a concatenated code, comprising:

   encoding a to-be-encoded message bit sequence by using a polar code, to obtain a first encoded codeword with a length of N_o, wherein N_o is a positive integer;
   encoding a second encoded codeword by using an improved low-density parity-check LDPC code, to obtain a concatenated code codeword with a length of N_i, wherein the second encoded codeword is determined based on the first encoded codeword, and N_i is a positive integer; and
   outputting the concatenated code codeword, wherein
   the first t columns of a base matrix of the improved LDPC code are all-zero columns, t is a positive integer, $2 \leq t < T$, T is equal to a ratio of N_o to p, p is a multiple by which the base matrix needs to be extended, and p is a positive integer; and
   a parity-check matrix of the improved LDPC code comprises at least s columns with a column weight of 1, the at least s columns comprise the last (N_i-N_o) columns, and s is a positive integer.

2. The method according to claim 1, wherein a size of the base matrix is m rows and n columns, and the method further comprises:

   constructing a row vector with a size of m and a column vector with a size of v, wherein any two elements in the row vector are different, any two elements in the column vector are different, m, n, and v are all positive integers, both m and v are less than or equal to p, and v=n, or v=n-t;
   obtaining a lifting matrix based on the row vector and the column vector;
   obtaining an updated base matrix based on the lifting matrix and the base matrix; and
   obtaining the parity-check matrix of the improved LDPC code based on the updated base matrix.

3. The method according to claim 2, wherein the obtaining a lifting matrix based on the row vector and the column vector comprises:

   constructing the lifting matrix $\mathbf{M}(i, j) = r_i \cdot c_j \bmod p$ , wherein
   the row vector is $\mathbf{C}_{rows} = (r_1, r_2, ..., r_m)$, $r_i$ is the $i^{th}$ element in the row vector $\mathbf{C}_{rows}$, $1 \leq i \leq m$, the column vector is $\mathbf{C}_{cols} = (c_1, c_2, ..., c_v)$, $c_j$ is the $j^{th}$ element in the column vector $\mathbf{C}_{cols}$, $1 \leq j \leq v$, and mod is a remainder operation.

4. The method according to claim 2 or 3, wherein the obtaining an updated base matrix based on the lifting matrix and the base matrix comprises:

   if v=n, determining that the updated base matrix $\mathbf{H}_m$ is represented as $\mathbf{H}_m = \mathbf{H}_{opt} \odot \mathbf{M}$; or
   if v=n-t, determining that the updated base matrix $\mathbf{H}_m$ is represented as $\mathbf{H}_m = \mathbf{H}_{opt2} \odot M$, wherein
   $\mathbf{H}_{opt}$ is the base matrix, $\mathbf{H}_{opt2}$ is a matrix obtained by extracting a non-zero column in the base matrix, and $\mathbf{M}$ is the lifting matrix.

5. The method according to any one of claims 2 to 4, wherein the obtaining the parity-check matrix of the improved LDPC code based on the updated base matrix comprises:

   if v=n, extending the updated base matrix by p times, to obtain the parity-check matrix; or
   if v=n-t, extending the updated base matrix by p times, to obtain an intermediate parity-check matrix, and padding the intermediate parity-check matrix with t*p all-zero columns, to obtain the parity-check matrix.

6. A decoding method of a concatenated code, comprising:

   obtaining a channel received vector with a length of N_i, wherein N_i is a length of an inner code of a concatenated code, the inner code of the concatenated code is an improved low-density parity-check LDPC code, an outer code of the concatenated code is a polar code, and N_i is a positive integer;

the first t columns of a base matrix of the improved LDPC code are all-zero columns, t is a positive integer, $2 \leq t < T$, T is equal to a ratio of N_o to p, p is a multiple by which the base matrix needs to be extended, and p is a positive integer; and

a parity-check matrix of the improved LDPC code comprises at least s columns with a column weight of 1, the at least s columns comprise the last (N_i-N_o) columns, and s is a positive integer; and

decoding the channel received vector, and outputting a decoding result.

7. The method according to claim 6, wherein a size of the base matrix is m rows and n columns, and the method further comprises:

constructing a row vector with a size of m and a column vector with a size of v, wherein any two elements in the row vector are different, any two elements in the column vector are different, m, n, and v are all positive integers, both m and v are less than or equal to p, and v=n, or v=n-t;

obtaining a lifting matrix based on the row vector and the column vector;

obtaining an updated base matrix based on the lifting matrix and the base matrix; and

obtaining the parity-check matrix of the improved LDPC code based on the updated base matrix.

8. The method according to claim 7, wherein the obtaining a lifting matrix based on the row vector and the column vector comprises:

constructing the lifting matrix $\mathbf{M}(i, j) = r_i \cdot c_j$, mod $p$ , wherein

the row vector is $\mathbf{C}_{rows} = (r_1, r_2, ..., r_m)$, $r_i$ is the $i^{th}$ element in the row vector $C_{rows}$, $1 \leq i \leq m$, the column vector is $\mathbf{C}_{cols} = (c_1, c_2, ..., c_v)$, $c_j$ is the $j^{th}$ element in the column vector $C_{cols}$, $1 \leq j \leq v$, and mod is a remainder operation.

9. The method according to claim 7 or 8, wherein the obtaining an updated base matrix based on the lifting matrix and the base matrix comprises:

if v=n, determining that the updated base matrix $\mathbf{H}_m$ is represented as $\mathbf{H}_m = \mathbf{H}_{opt} \odot \mathbf{M}$; or

if v=n-t, determining that the updated base matrix $\mathbf{H}_m$ is represented as $\mathbf{H}_m = \mathbf{H}_{opt2} \odot \mathbf{M}$, wherein

$\mathbf{H}_{opt}$ is the base matrix, $\mathbf{H}_{opt2}$ is a matrix obtained by extracting a non-zero column in the base matrix, and M is the lifting matrix.

10. The method according to any one of claims 7 to 9, wherein the obtaining the parity-check matrix of the improved LDPC code based on the updated base matrix comprises:

if v=n, extending the updated base matrix by p times, to obtain the parity-check matrix; or

if v=n-t, extending the updated base matrix by p times, to obtain an intermediate parity-check matrix, and padding the intermediate parity-check matrix with t*p all-zero columns, to obtain the parity-check matrix.

11. A communication apparatus, comprising:
a processing unit, configured to:

encode a to-be-encoded message bit sequence by using a polar code, to obtain a first encoded codeword with a length of N_o, wherein N_o is a positive integer; and

encode a second encoded codeword by using an improved low-density parity-check LDPC code, to obtain a concatenated code codeword with a length of N_i, wherein the second encoded codeword is determined based on the first encoded codeword, and N_i is a positive integer; and

a transceiver unit, configured to output the concatenated code codeword, wherein

the first t columns of a base matrix of the improved LDPC code are all-zero columns, t is a positive integer, $2 \leq t < T$, T is equal to a ratio of N_o to p, p is a multiple by which the base matrix needs to be extended, and p is a positive integer; and

a parity-check matrix of the improved LDPC code comprises at least s columns with a column weight of 1, the at least s columns comprise the last (N_i-N_o) columns, and s is a positive integer.

12. The communication apparatus according to claim 11, wherein a size of the base matrix is m rows and n columns, and the processing unit is further configured to:

construct a row vector with a size of m and a column vector with a size of v, wherein any two elements in the row vector are different, any two elements in the column vector are different, m, n, and v are all positive integers, both m and v are less than or equal to p, and v=n, or v=n-t;

obtain a lifting matrix based on the row vector and the column vector;

obtain an updated base matrix based on the lifting matrix and the base matrix; and

obtain the parity-check matrix of the improved LDPC code based on the updated base matrix.

13. The communication apparatus according to claim 12, wherein the processing unit is specifically configured to:

construct the lifting matrix $\mathbf{M}(i, j)=r_i \cdot c_j \bmod p$, wherein

the row vector is $\mathbf{C}_{rows}=(r_1,r_2,...,r_m)$, $r_i$ is the $i^{th}$ element in the row vector $\mathbf{C}_{rows}$, $1 \leq i \leq m$, the column vector is $\mathbf{C}_{cols}=(c_1,c_2,...,c_v)$, $c_j$ is the $j^{th}$ element in the column vector $C_{cols}$, $1 \leq j \leq v$, and mod is a remainder operation.

14. The communication apparatus according to claim 12 or 13, wherein the processing unit is specifically configured to:

if v=n, determine that the updated base matrix $\mathbf{H}_m$ is represented as $\mathbf{H}_m=\mathbf{H}_{opt} \odot \mathbf{M}$; or

if v=n-t, determine that the updated base matrix $\mathbf{H}_m$ is represented as $\mathbf{H}_m=\mathbf{H}_{opt2} \odot \mathbf{M}$, wherein $\mathbf{H}_{opt}$ is the base matrix, $\mathbf{H}_{opt2}$ is a matrix obtained by extracting a non-zero column in the base matrix, and $\mathbf{M}$ is the lifting matrix.

15. The communication apparatus according to any one of claims 12 to 14, wherein the processing unit is specifically configured to:

if v=n, extend the updated base matrix by p times, to obtain the parity-check matrix; or

if v=n-t, extend the updated base matrix by p times, to obtain an intermediate parity-check matrix, and pad the intermediate parity-check matrix with t*p all-zero columns, to obtain the parity-check matrix.

16. A communication apparatus, comprising:

a transceiver unit, configured to obtain a channel received vector with a length of N_i, wherein N_i is a length of an inner code of a concatenated code, the inner code of the concatenated code is an improved low-density parity-check LDPC code, an outer code of the concatenated code is a polar code, and N_i is a positive integer;

the first t columns of a base matrix of the improved LDPC code are all-zero columns, t is a positive integer, 2≤t<T, T is equal to a ratio of N_o to p, p is a multiple by which the base matrix needs to be extended, and p is a positive integer; and

a parity-check matrix of the improved LDPC code comprises at least s columns with a column weight of 1, the at least s columns comprise the last (N_i-N_o) columns, and s is a positive integer; and

a processing unit, configured to decode the channel received vector, wherein

the transceiver unit is further configured to output a decoding result.

17. The communication apparatus according to claim 16, wherein a size of the base matrix is m rows and n columns, and the processing unit is further configured to:

construct a row vector with a size of m and a column vector with a size of v, wherein any two elements in the row vector are different, any two elements in the column vector are different, m, n, and v are all positive integers, both m and v are less than or equal to p, and v=n, or v=n-t;

obtain a lifting matrix based on the row vector and the column vector;

obtain an updated base matrix based on the lifting matrix and the base matrix; and

obtain the parity-check matrix of the improved LDPC code based on the updated base matrix.

18. The communication apparatus according to claim 17, wherein the processing unit is specifically configured to:

construct the lifting matrix $\mathbf{M}(i, j)=r_i \cdot c_j \bmod p$, wherein

the row vector is $\mathbf{C}_{rows}=(r_1,r_2,...,r_m)$, $r_i$ is the $i^{th}$ element in the row vector $\mathbf{C}_{rows}$, $1 \leq i \leq m$, the column vector is $\mathbf{C}_{cols}=(c_1,c_2,...,c_v)$, $c_j$ is the $j^{th}$ element in the column vector $C_{cols}$, $1 \leq j \leq v$, and mod is a remainder operation.

19. The communication apparatus according to claim 17 or 18, wherein the processing unit is specifically configured to:

if v=n, determine that the updated base matrix $\mathbf{H}_m$ is represented as $\mathbf{H}_m=\mathbf{H}_{opt} \odot \mathbf{M}$; or

if v=n-t, determine that the updated base matrix $\mathbf{H}_m$ is represented as $\mathbf{H}_m=\mathbf{H}_{opt2}\odot M$, wherein $\mathbf{H}_{opt}$ is the base matrix, $\mathbf{H}_{opt2}$ is a matrix obtained by extracting a non-zero column in the base matrix, and $\mathbf{M}$ is the lifting matrix.

20. The communication apparatus according to any one of claims 17 to 19, wherein the processing unit is specifically configured to:

if v=n, extend the updated base matrix by p times, to obtain the parity-check matrix; or
if v=n-t, extend the updated base matrix by p times, to obtain an intermediate parity-check matrix, and pad the intermediate parity-check matrix with t*p all-zero columns, to obtain the parity-check matrix.

21. A communication apparatus, comprising at least one processor, wherein the at least one processor is coupled to at least one memory, and the at least one processor is configured to execute a computer program or instructions stored in the at least one memory, to enable the communication apparatus to perform the method according to any one of claims 1 to 5 or the method according to any one of claims 6 to 10.

22. A chip, comprising a processor and a communication interface, wherein the communication interface is configured to receive a to-be-encoded message bit sequence, and send the to-be-encoded message bit sequence to the processor; the processor performs concatenated encoding on the to-be-encoded message bit sequence according to the method according to any one of claims 1 to 5, to obtain a concatenated codeword; and the communication interface is further configured to output the concatenated codeword; or
the communication interface is configured to receive a channel received vector, and send the channel received vector to the processor; the processor performs decoding of a concatenated code according to the method according to any one of claims 6 to 10, to obtain a decoding result; and the communication interface is configured to output the decoding result.

23. A computer-readable storage medium, wherein the computer-readable storage medium stores computer instructions, and when the computer instructions are run on a computer, the method according to any one of claims 1 to 5 or the method according to any one of claims 6 to 10 is implemented.

24. A computer program product, wherein the computer program product comprises computer program code, and when the computer program code is run on a computer, the method according to any one of claims 1 to 5 or the method according to any one of claims 6 to 10 is implemented.

25. A system, comprising the communication apparatus according to any one of claims 11 to 15, and comprising the communication apparatus according to any one of claims 16 to 20.

Network device

Terminal

Terminal

FIG. 1

FIG. 2

```
┌──────────┐
│  Source  │
└────┬─────┘
     │
     ▼
┌──────────┐
│  Source  │
│ encoding │
└────┬─────┘
     │
     ▼
┌──────────┐
│ Channel  │
│ encoding │
└────┬─────┘
     │
     ▼
┌──────────┐
│Modulation│
└────┬─────┘
     │
     ▼
┌──────────┐
│ Channel  │
└────┬─────┘
     │
     ▼
┌──────────┐
│Demodula- │
│   tion   │
└────┬─────┘
     │
     ▼
┌──────────┐
│ Channel  │
│ decoding │
└────┬─────┘
     │
     ▼
┌──────────┐
│  Source  │
│ decoding │
└────┬─────┘
     │
     ▼
┌──────────┐
│   Sink   │
└──────────┘
```

Super channel

| Outer code | → | Inner code | → | Channel | → | Inner code | → | Outer code |

FIG. 3

To-be-encoded message bit sequence $u$ → Encoding by using an outer code, a polar code → $c$ → Interleaver → $P(c)$ → Encoding by using an inner code, an ER-LDPC code → $C\_N\text{-}ER\text{-}LDPC(P(c))$ → Channel

Soft information iterative decoding scheme of a concatenated code

Hard decision ← Soft SCL decoder of the polar code ⇄ Soft SISO decoder of N-ER-LDPC ← Channel received vector $y$

Estimated sequence from decoding

FIG. 4

500

| Transmitting end | | Receiving end |

S510: Perform concatenated encoding on a to-be-encoded message bit sequence, to obtain a concatenated code codeword

S520: Concatenated code codeword ⟶

S530: Decode a channel received vector by using a soft information iterative decoding scheme, to obtain an estimated sequence from decoding

FIG. 5

K bits → CRC encoder → K+r bits → Polar encoder → $N_o$ bits → Interleaver → $N_o$ bits → N-ER-LDPC encoder → $N_i$ bits

FIG. 6

700

| Encode a to-be-encoded message bit sequence by using a polar code, to obtain a first encoded codeword with a length of N_o | S710 |

| Interleave the first encoded codeword, to obtain a second encoded codeword | S720 |

| Encode the second encoded codeword by using an improved LDPC code, to obtain a concatenated code codeword with a length of N_i, where the first t columns of a base matrix of the improved LDPC code are all-zero columns, t is a positive integer, $2 \leq t < T$; and a parity-check matrix of the improved LDPC code includes at least s columns with a column weight of 1, and the at least s columns include the last (N_i–N_o) columns | S730 |

| Output the concatenated code codeword | S740 |

FIG. 7

Non-zero elements=218

FIG. 8

FIG. 9

1000

Obtain a channel received vector with a length of N_i, where N_i is a length of an inner code of a concatenated code, the inner code of the concatenated code is an improved LDPC code, an outer code of the concatenated code is a polar code, and N_i is a positive integer ⟋ S1010

Decode the channel received vector according to an SISO decoding algorithm of the improved LDPC code, to obtain a first soft information sequence with a length of N_i ⟋ S1020

De-interleave the first soft information sequence, to obtain a de-interleaved first soft information sequence, and extract soft information in the first N_o positions from the de-interleaved first soft information sequence, to obtain a second soft information sequence, where N_o is a length of the outer code of the concatenated code, and N_o is a positive integer ⟋ S1030

Perform soft information iterative decoding based on the second soft information sequence, the channel received vector, and a preset maximum quantity of iterations of the concatenated code according to a soft SCL decoding algorithm of the polar code and the SISO decoding algorithm of the improved LDPC code, to obtain a third soft information sequence ⟋ S1040

Perform a hard decision on the third soft information sequence, to obtain an estimated sequence from decoding ⟋ S1050

Output the estimated sequence from decoding ⟋ S1060

FIG. 10

$y$ → [Soft SISO decoder of an N-ER-LDPC code] + (⊕) − → [De-interleaver $P_{inv}$] → [Soft SCL decoder of a polar code] → Lcode

[P] − (⊕) +

FIG. 11

FIG. 12

Communication apparatus 1300

Processing unit 1310

Transceiver unit 1320

FIG. 13

Communication apparatus 1400

Processor
1410

Memory
1420

Communication
interface
1430

FIG. 14

## INTERNATIONAL SEARCH REPORT

| International application No. |
|---|
| **PCT/CN2023/120418** |

| A. | CLASSIFICATION OF SUBJECT MATTER |
|---|---|

H04L1/00(2006.01)i

According to International Patent Classification (IPC) or to both national classification and IPC

| B. | FIELDS SEARCHED |
|---|---|

Minimum documentation searched (classification system followed by classification symbols)

IPC: H04L

Documentation searched other than minimum documentation to the extent that such documents are included in the fields searched

Electronic data base consulted during the international search (name of data base and, where practicable, search terms used)

CNTXT; DWPI; ENTXT; CNKI; 3GPP: 级联, 极化码, 低密度奇偶校验, 矩阵, 零, 比值, 比率, 扩展, 倍, 零, concatenation, polar code, LDPC, matrix, zero, ratio, extension, multiple, zero

| C. | DOCUMENTS CONSIDERED TO BE RELEVANT |
|---|---|

| Category* | Citation of document, with indication, where appropriate, of the relevant passages | Relevant to claim No. |
|---|---|---|
| A | CN 108055044 A (CHINA JILIANG UNIVERSITY) 18 May 2018 (2018-05-18)<br>entire document | 1-25 |
| A | CN 110582958 A (QUALCOMM INC.) 17 December 2019 (2019-12-17)<br>entire document | 1-25 |
| A | CN 110326342 A (HUAWEI TECHNOLOGIES CO., LTD.) 11 October 2019 (2019-10-11)<br>entire document | 1-25 |
| A | CN 110089037 A (HUAWEI TECHNOLOGIES CO., LTD.) 02 August 2019 (2019-08-02)<br>entire document | 1-25 |
| A | HUAWEI, HISILICON. "Polar Codes-Encoding And Decoding"<br>*R1-164039, 3GPP TSG RAN WG1,* 14 May 2016 (2016-05-14),<br>entire document | 1-25 |

☐ Further documents are listed in the continuation of Box C.　　☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **28 December 2023** | **29 December 2023** |

| Name and mailing address of the ISA/CN | Authorized officer |
|---|---|
| **China National Intellectual Property Administration (ISA/CN)**<br>**China No. 6, Xitucheng Road, Jimenqiao, Haidian District, Beijing 100088** | |
| | Telephone No. |

Form PCT/ISA/210 (second sheet) (July 2022)

## INTERNATIONAL SEARCH REPORT
### Information on patent family members

International application No.

**PCT/CN2023/120418**

| Patent document cited in search report | | | Publication date (day/month/year) | Patent family member(s) | | | Publication date (day/month/year) |
|---|---|---|---|---|---|---|---|
| CN | 108055044 | A | 18 May 2018 | None | | | |
| CN | 110582958 | A | 17 December 2019 | EP | 3619850 | A1 | 11 March 2020 |
| | | | | EP | 3619850 | A4 | 27 January 2021 |
| | | | | KR | 20200003796 | A | 10 January 2020 |
| | | | | WO | 2018201753 | A1 | 08 November 2018 |
| | | | | US | 2020099393 | A1 | 26 March 2020 |
| | | | | JP | 2020520141 | A | 02 July 2020 |
| | | | | JP | 7195273 | B2 | 23 December 2022 |
| | | | | TW | 201843939 | A | 16 December 2018 |
| | | | | TWI | 769247 | B | 01 July 2022 |
| | | | | CA | 3056835 | A1 | 01 November 2018 |
| | | | | BR | 112019022655 | A2 | 19 May 2020 |
| | | | | WO | 2018201404 | A1 | 08 November 2018 |
| CN | 110326342 | A | 11 October 2019 | EP | 3583812 | A1 | 25 December 2019 |
| | | | | EP | 3583812 | A4 | 24 June 2020 |
| | | | | EP | 3583812 | B1 | 11 May 2022 |
| | | | | WO | 2018153260 | A1 | 30 August 2018 |
| | | | | US | 2018248654 | A1 | 30 August 2018 |
| | | | | US | 10608786 | B2 | 31 March 2020 |
| CN | 110089037 | A | 02 August 2019 | BR | 112019012985 | A2 | 03 December 2019 |
| | | | | US | 2018183464 | A1 | 28 June 2018 |
| | | | | US | 10554223 | B2 | 04 February 2020 |
| | | | | EP | 3549265 | A1 | 09 October 2019 |
| | | | | EP | 3549265 | A4 | 13 November 2019 |
| | | | | JP | 2020504508 | A | 06 February 2020 |
| | | | | WO | 2018113705 | A1 | 28 June 2018 |

Form PCT/ISA/210 (patent family annex) (July 2022)

**EP 4 586 524 A1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- RU 2022125446